# EUROPEAN PATENT SPECIFICATION

(11) **EP 4 336 685 B1**
(45) Date of publication and mention of the grant of the patent: **08.04.2026**
(21) Application number: 22807029.8
(22) Date of filing: 02.02.2022
(51) Int. Cl.: H01S 5/183, H01S 5/42

(54) **SURFACE EMITTING LASER ELEMENT, ELECTRONIC DEVICE, AND METHOD FOR PRODUCING SURFACE EMITTING LASER ELEMENT**
OBERFLÄCHENEMITTIERENDES LASERELEMENT, ELEKTRONISCHE VORRICHTUNG UND VERFAHREN ZUR HERSTELLUNG EINES OBERFLÄCHENEMITTIERENDEN LASERELEMENTS
ÉLÉMENT LASER À ÉMISSION PAR LA SURFACE, DISPOSITIF ÉLECTRONIQUE ET PROCÉDÉ DE PRODUCTION D'UN ÉLÉMENT LASER À ÉMISSION PAR LA SURFACE

(30) Priority: 14.05.2021 JP 2021082519
(43) Date of publication of application: 13.03.2024
(73) Proprietor: Sony Semiconductor Solutions Corporation, Atsugi-shi, Kanagawa 243-0014 (JP)
(72) Inventor: MITOMO, Jugo, Kikuchi-gun, Kumamoto 869-1102 (JP); TOKUDA, Kota, Atsugi-shi, Kanagawa 243-0014 (JP)
(74) Representative: D Young & Co LLP
(86) International application number: PCT/JP2022/003911
(87) International publication number: WO 2022/239322

(56) References cited:
- CN-A- 111 313 233
- JP-A- 2009 164 466
- JP-A- 2013 065 692
- JP-A- 2016 021 516
- JP-A- 2017 168 715
- JP-B2- 3 965 801
- US-A1- 2003 138 017
- US-A1- 2017 271 851
- US-B2- 8 937 982

## Description

### TECHNICAL FIELD

The technology according to the present disclosure (hereinafter also referred to as "the present technology") relates to a surface emitting laser element, an electronic device, and a method for manufacturing a surface emitting laser element.

### BACKGROUND ART

Conventionally, a surface emitting laser element including a first region in which a plurality of light emitting units including mesas is arranged and a second region around the first region is known (see, for example, Patent Document 1).

### CITATION LIST

### PATENT DOCUMENT

PATENT DOCUMENT 1: Japanese Patent Application Laid-Open No. 2014-132692
PATENT DOCUMENT 2: US 2017/271851 A1
PATENT DOCUMENT 3: CN 111313233 A
PATENT DOCUMENT 4: JP 3965801 B2
PATENT DOCUMENT 5: US 8937982 B2

### SUMMARY OF THE INVENTION

### PROBLEMS TO BE SOLVED BY THE INVENTION

However, in the conventional surface emitting laser element, there is room for improvement in reducing variations in light emission intensity between light emitting units adjacent to the second region and light emitting units other than the light emitting units.

Therefore, the present technology provides a surface emitting laser element capable of reducing variation in light emission intensity between light emitting units adjacent to the second region and light emitting units other than the light emitting units.

### SOLUTIONS TO PROBLEMS

Embodiments of the present disclosure are defined by the appended set of claims.

### BRIEF DESCRIPTION OF DRAWINGS

Fig. 1 is a cross-sectional view (part 1) of a surface emitting laser element according to one embodiment of the present technology.
Fig. 2 is a cross-sectional view (part 2) of a surface emitting laser element according to one embodiment of the present technology.
Fig. 3 is a plan view of a surface emitting laser element according to one embodiment of the present technology.
Fig. 4 is a flowchart for explaining a first example of a method for manufacturing a surface emitting laser element according to one embodiment of the present technology.
Fig. 5 is a cross-sectional view illustrating a first step in Fig. 4.
Fig. 6 is a cross-sectional view illustrating a first sub-step of a second step in Fig. 4.
Fig. 7 is a cross-sectional view illustrating a second sub-step of a second step in Fig. 4.
Fig. 8 is a cross-sectional view illustrating a third sub-step of a second step in Fig. 4.
Fig. 9 is a cross-sectional view illustrating a first sub-step of a third step in Fig. 4.
Fig. 10 is a cross-sectional view illustrating a second sub-step of a third step in Fig. 4.
Fig. 11 is a cross-sectional view illustrating a third sub-step of a third step in Fig. 4.
Fig. 12 is a cross-sectional view illustrating a fourth step in Fig. 4.
Fig. 13 is a cross-sectional view illustrating a fifth step in Fig. 4.
Fig. 14 is a cross-sectional view illustrating a sixth step in Fig. 4.
Fig. 15 is a cross-sectional view illustrating a seventh step in Fig. 4.
Fig. 16 is a cross-sectional view illustrating an eighth step in Fig. 4.
Fig. 17 is a flowchart for explaining a second example of a method for manufacturing a surface emitting laser element according to one embodiment of the present technology.
Fig. 18 is a cross-sectional view illustrating a first sub-step of a third step in Fig. 17.
Fig. 19 is a cross-sectional view illustrating a second sub-step of a third step in Fig. 17.
Fig. 20 is a cross-sectional view illustrating a third sub-step of a third step in Fig. 17.
Fig. 21 is a cross-sectional view illustrating a first sub-step of a fourth step in Fig. 17.
Fig. 22 is a cross-sectional view illustrating a second sub-step of a fourth step in Fig. 17.
Fig. 23 is a flowchart for explaining a third example of a method for manufacturing a surface emitting laser element according to one embodiment of the present technology.
Fig. 24 is a cross-sectional view illustrating a first sub-step of a third step in Fig. 23.
Fig. 25 is a cross-sectional view illustrating a second sub-step of a third step in Fig. 23.
Fig. 26 is a cross-sectional view illustrating a third sub-step of a third step in Fig. 23.
Fig. 27 is a cross-sectional view illustrating a first sub-step of a fourth step in Fig. 23.
Fig. 28 is a cross-sectional view illustrating a second sub-step of a fourth step in Fig. 23.
Fig. 29 is a diagram for explaining an action of a surface emitting laser element according to one embodiment of the present technology.
Fig. 30 is a diagram for explaining an action of a surface emitting laser element of a comparative example.
Fig. 31 is a cross-sectional view of a surface emitting laser element according to Modification 1 of one embodiment of the present technology.
Fig. 32 is a cross-sectional view of a surface emitting laser element according to Modification 2 of one embodiment of the present technology.
Fig. 33 is a cross-sectional view of a surface emitting laser element according to Modification 3 of one embodiment of the present technology.
Fig. 34 is a cross-sectional view of a surface emitting laser element according to Modification 4 of one embodiment of the present technology.
Fig. 35 is a cross-sectional view of a surface emitting laser element according to Modification 5 of one embodiment of the present technology.
Fig. 36 is a cross-sectional view of a surface emitting laser element according to Modification 6 of one embodiment of the present technology.
Fig. 37 is a cross-sectional view (part 1) of a surface emitting laser element according to Modification 7 of one embodiment of the present technology.
Fig. 38 is a cross-sectional view (part 2) of a surface emitting laser element according to Modification 7 of one embodiment of the present technology.
Fig. 39 is a plan view of a surface emitting laser element according to Modification 7 of one embodiment of the present technology.
Fig. 40 is a plan view of a surface emitting laser element according to Modification 8 of one embodiment of the present technology.
Fig. 41 is a plan view of a surface emitting laser element according to Modification 9 of one embodiment of the present technology.
Fig. 42 is a diagram illustrating an application example of a surface emitting laser element according to one embodiment of the present technology to a distance measuring device.
Fig. 43 is a block diagram illustrating an example of a schematic configuration of a vehicle control system.
Fig. 44 is an explanatory diagram illustrating an example of an installation position of a distance measuring device.

### MODE FOR CARRYING OUT THE INVENTION

Hereinafter, a preferred embodiment of the present technology will be described in detail with reference to the accompanying drawings. Note that in the present specification and the drawings, components having substantially the same functional configurations are denoted by the same reference numerals, and redundant descriptions are omitted. The embodiment described below provide a representative embodiment of the present technology, and the scope of the present technology is not to be narrowly interpreted according to these embodiments. In the present specification, even in a case where it is described that each of a surface emitting laser element, an electronic device, and a manufacturing method for the surface emitting laser element according to the present technology exhibits a plurality of effects, it suffices that each of the surface emitting laser element, the electronic device, and the manufacturing method for the surface emitting laser element according to the present technology exhibits at least one effect. The effects described herein are merely examples and are not limited, and other effects may be provided.

Furthermore, the description will be given in the following order.
1. Configuration of Surface Emitting Laser Element According to Embodiment of Present Technology
2. Operation of Surface Emitting Laser Element According to Embodiment of Present Technology
3. First Example of Method for Manufacturing Surface Emitting Laser Element According to Embodiment of Present Technology
4. Second Example of Method for Manufacturing Surface Emitting Laser Element According to Embodiment of Present Technology
5. Third Example of Method for Manufacturing Surface Emitting Laser Element According to Embodiment of Present Technology
6. Effects of Surface Emitting Laser Element According to Embodiment of Present Technology and Effects of Manufacturing Method Thereof
7. Surface Emitting Laser Element According to Modifications 1 to 9 of Embodiment of Present Technology
8. Other Modifications of Embodiment of Present Technology
9. Application Example to Electronic Device
10. Example in Which Surface Emitting Laser Element Is Applied to Distance Measuring Device
11. Example in Which Distance Measuring Device Is Mounted on Mobile Body

### 1. <Configuration of Surface Emitting Laser Element According to Embodiment of Present Technology>

### (Overall Configuration)

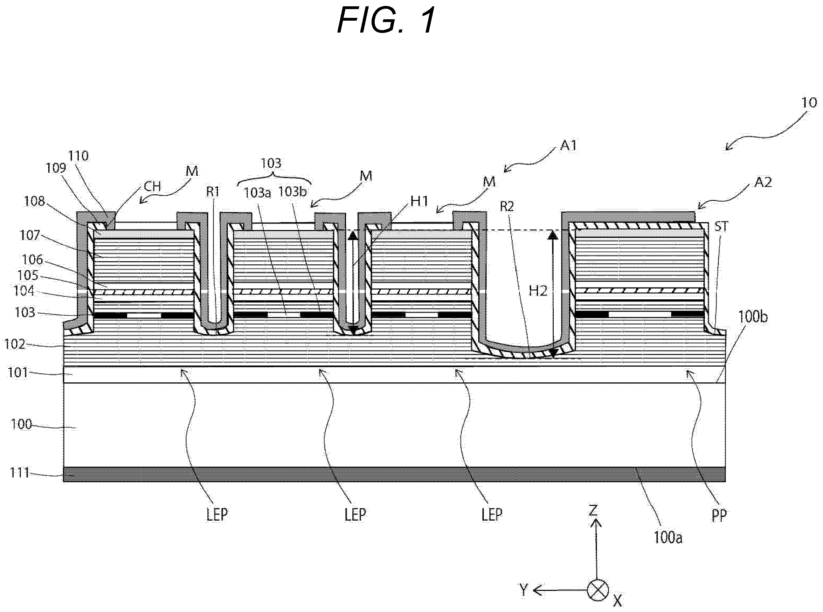

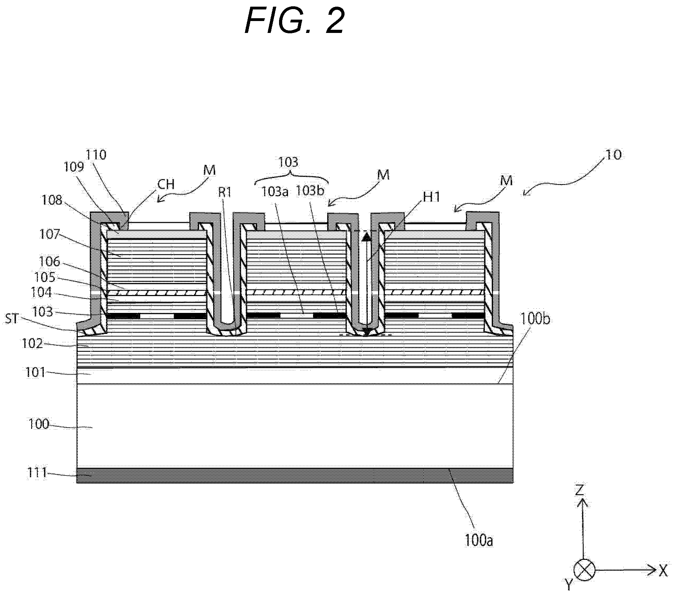

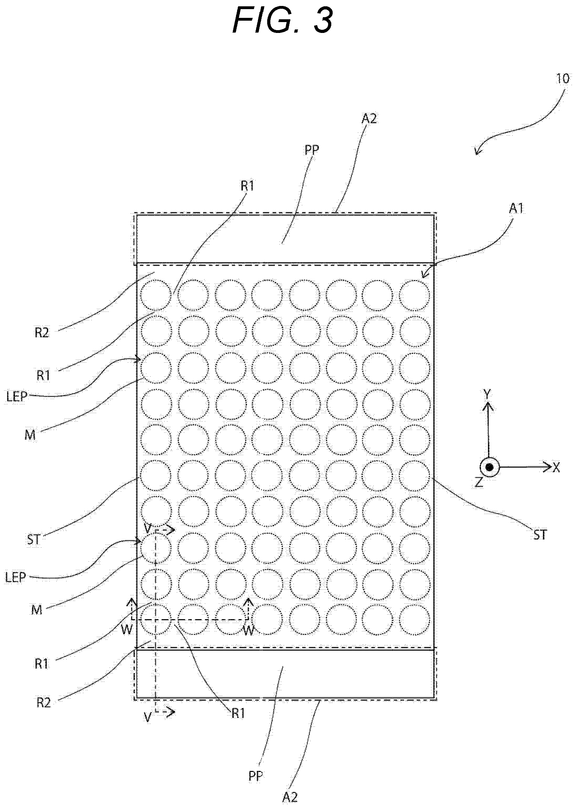

Fig. 1 is a cross-sectional view (part 1) of a surface emitting laser element according to one embodiment of the present technology. Fig. 2 is a cross-sectional view (part 2) of the surface emitting laser element according to one embodiment of the present technology. Fig. 3 is a plan view of a surface emitting laser element according to one embodiment of the present technology.

Hereinafter, the description will be made by using an XYZ three-dimensional orthogonal coordinate system illustrated in Figs. 1 to 3 as appropriate.

Fig. 1 is a cross-sectional view (YZ cross-sectional view) taken along line V-V of Fig. 3. Fig. 2 is a cross-sectional view (XZ cross-sectional view) taken along line W-W of Fig. 3.

As an example, as illustrated in Fig. 1, a surface emitting laser element 10 according to one embodiment includes a substrate 100, a cathode electrode 111 provided on one surface 100a (hereinafter also referred to as "back surface") of the substrate 100, a first region A1 provided on the side of the one surface 100a opposite to the cathode electrode side 111 and in which a plurality of light emitting units LEP including mesas M is arranged, and a second region A2 arranged around the first region A1 on the side of the one surface 100a of the substrate 100 opposite to the cathode electrode 111 side.

Hereinafter, the description will be appropriately made assuming that the one surface 100a side of the substrate 100 is the lower side (-Z side) and the top portion side of each mesa M is the upper side (+Z side).

In the surface emitting laser element 10, as an example, as illustrated in Fig. 3, the second regions A2 (regions surrounded by two-dot chain lines) are arranged on both sides sandwiching the first region A1 in the Y-axis direction in plan view.

In the first region A1, as an example, a plurality of light emitting units LEP including mesas M is two-dimensionally arranged. Each of the light emitting units LEP is a vertical cavity surface emitting laser (VCSEL).

Here, the plurality of light emitting units LEP is arranged in a matrix shape (square lattice shape) at equal intervals in both the X-axis direction and the Y-axis direction as an example, but may be arranged in another layout such as a zigzag shape or a random shape.

As can be seen from Figs. 1 to 3, each mesa M has a substantially cylindrical shape as an example, but may have another shape such as a substantially truncated cone shape, a substantially elliptical frustum shape, or a substantially polygonal frustum shape.

The upper surface of each mesa M is substantially flush.

Here, the pitch of two mesas M adjacent to each other in the X-axis direction or the Y-axis direction in the first region A1 (the interval between the centers of the two mesas M) is set to, for example, 10 µm or more and 50 µm or less (preferably about 20 µm).

As an example, as illustrated in Figs. 1 and 3, the second region A2 has a protruding portion PP in which the upper surface and the upper surface of each mesa M are substantially flush with each other. The protruding portion PP extends in the X-axis direction.

Returning to Fig. 1, as an example, the first and second regions A1 and A2 are provided at different positions in the in-plane direction of the laminated structure including the substrate 100. In the laminated structure, as an example, a first multilayer film reflector 102, an active layer 105, and a second multilayer film reflector 107 are laminated in this order on the side (+Z side) opposite to the cathode electrode 111 side (-Z side) of the one surface 100a of the substrate 100. A laminating direction in the laminated structure coincides with a Z-axis direction.

Furthermore, in the laminated structure, as an example, a spacer layer 101 is disposed between the substrate 100 and the first multilayer film reflector 102.

Furthermore, in the laminated structure, as an example, an oxidation confinement layer 103 is disposed in the first multilayer film reflector 102.

Furthermore, in the laminated structure, as an example, the first and second cladding layers 104 and 105 are disposed on both sides sandwiching the active layer 105 in the Z-axis direction between the first and second multilayer film reflectors 102 and 107. The second cladding layer 106 is located on the upper side (+Z side) of the first cladding layer 104.

Furthermore, in the laminated structure, as an example, a contact layer 108 is disposed on the upper surface (+Z side surface) of the second multilayer film reflector 107.

As an example, each light emitting unit LEP includes the first multilayer film reflector 102, the active layer 105, and the second multilayer film reflector 107. More specifically, each light emitting unit LEP includes, as an example, the first multilayer film reflector 102, the oxidation confinement layer 103, the first cladding layer 104, the active layer 105, the second cladding layer 106, the second multilayer film reflector 107, and the contact layer 108.

As an example, the mesa M of each light emitting unit LEP includes an upper portion of the first multilayer film reflector 102, the active layer 105, and the second multilayer film reflector 107. More specifically, the mesa M of each light emitting unit LEP includes, as an example, an upper portion of the first multilayer film reflector 102, the oxidation confinement layer 103, the first cladding layer 104, the active layer 105, the second cladding layer 106, the second multilayer film reflector 107, and the contact layer 108.

As an example, the second region A2 has the same layer configuration as that of the light emitting unit LEP. The protruding portion PP in the second region A2 has, for example, a layer configuration substantially similar to that of the mesa M.

The first region A1 and the second region A2 are covered with an insulating film 109. A contact hole CH is provided in a portion covering the top portion of each mesa M of the insulating film 109.

An anode electrode 110 is provided on the insulating film 109. The anode electrode 110 is disposed so as to be in contact with the contact layer 108 via the contact hole CH provided on the top portion of each mesa M.

More specifically, the anode electrode 110 is in contact with the contact layer 108 via the peripheral portion of the contact hole CH of each mesa M. The inside of the anode electrode 110 (the central portion of the contact hole CH) on each mesa M is an emission port of the light emitting unit LEP having the mesa M. The emission direction of each light emitting unit LEP is the +Z direction.

### (Substrate)

The substrate 100 is, for example, a GaAs substrate of a first conductivity type (for example, n-type).

### (Cathode Electrode)

As an example, the cathode electrode 111 (n-side electrode) is a common electrode provided in common for a plurality of light emitting units (here, all light emitting units). As an example, the cathode electrode 111 is provided in a solid state in substantially the entire region of the back surface of the substrate 100.

The cathode electrode 111 may have a single layer structure or a laminated structure.

The cathode electrode 111 is constituted by, for example, at least one type of metal (including an alloy) selected from a group including Au, Ag, Pd, Pt, Ni, Ti, V, W, Cr, Al, Cu, Zn, Sn, and In.

In a case where the cathode electrode 111 has a laminated structure, the cathode electrode 111 is constituted by a material such as, for example, Ti/Au, Ti/Al, Ti/Al/Au, Ti/Pt/Au, Ni/Au, Ni/Au/Pt, Ni/Pt, Pd/Pt, or Ag/Pd.

The cathode electrode 111 is electrically connected to the cathode side (negative electrode side) of the laser driver including the driver IC.

### (Spacer Layer)

The spacer layer 101 is constituted by, for example, a first conductivity type (for example, n-type) AlGaAs-based compound semiconductor. The spacer layer 101 is also referred to as a "buffer layer".

### (First Multilayer Film Reflector)

As an example, the first multilayer film reflector 102 is a semiconductor multilayer film reflector. The multilayer film reflector is also referred to as a distributed Bragg reflector. A semiconductor multilayer film reflector which is a type of multilayer film reflector (distributed Bragg reflector) has low light absorption, high reflectance, and conductivity. The first multilayer film reflector 102 is also referred to as a lower DBR.

The first multilayer film reflector 102 is, as an example, a semiconductor multilayer film reflector of the first conductivity type, and has a structure in which a plurality of types (for example, two types) of semiconductor layers (refractive index layers) having different refractive indexes is alternately laminated with an optical thickness of 1/4 (λ/4) of an oscillation wavelength λ. Each refractive index layer of the first multilayer film reflector 102 is constituted by a first conductivity type (for example, n-type) AlGaAs-based compound semiconductor.

### (Oxidation Confinement Layer)

As an example, the oxidation confinement layer 103 includes a non-oxidized region 103a constituted by AlAs and an oxidized region 103b constituted by an oxide of AlAs (for example, Al₂O₃) and surrounding the outer periphery of the non-oxidized region 103a.

### (First Cladding Layer)

The first cladding layer 104 is constituted by a first conductivity type (for example, n-type) AlGaAs-based compound semiconductor.

### (Active Layer)

The active layer 105 has a quantum well structure including a barrier layer including, for example, an AlGaAs-based compound semiconductor, and a quantum well layer. This quantum well structure may be a single quantum well structure (QW structure) or a multiple quantum well structure (MQW structure).

### (Second Cladding Layer)

The second cladding layer 106 is constituted by a second conductivity type (for example, p-type) AlGaAs-based compound semiconductor.

The active layer 105 and the first and second cladding layers 104 and 106 constitute a resonator.

### (Second Multilayer Film Reflector)

The second multilayer film reflector 107 is, as an example, a semiconductor multilayer film reflector of the second conductivity type, and has a structure in which a plurality of types (for example, two types) of semiconductor layers (refractive index layers) having different refractive indexes is alternately laminated with an optical thickness of 1/4 wavelength of the oscillation wavelength. Each refractive index layer of the second multilayer film reflector 107 is constituted by a second conductivity type (for example, p-type) AlGaAs-based compound semiconductor.

### (Contact Layer)

The contact layer 108 is constituted by a GaAs-based compound semiconductor of the second conductivity type (for example, p-type).

### (Insulating Film)

The insulating film 109 is constituted by a dielectric such as SiO₂, SiN, or SiON.

### (Anode Electrode)

As illustrated in Figs. 1 and 2, the anode electrode 110 (p-side electrode) is an electrode commonly provided on the top portion of at least one mesa M adjacent to a second region A2 and on the top portion of at least two mesas M not adjacent to the second region A2. Here, as an example, the anode electrode 110 is a common electrode common to the mesa M of all the light emitting units LEP. Note that, for example, the anode electrode 110 may be provided in common for each of a plurality of mesa rows arranged in the X-axis direction, each of which includes a plurality of mesas M arranged in the Y-axis direction in Fig. 3, or may be provided in common for at least two mesa rows among the plurality of mesa rows.

The anode electrode 110 is provided so as to cover the mesa M (excluding the central portion of the top portion of the mesa M) of the plurality of light emitting units LEP and a part of the protruding portion PP.

The anode electrode 110 may have a single layer structure or a laminated structure.

The anode electrode 110 is constituted by, for example, at least one type of metal (including an alloy) selected from a group including Au, Ag, Pd, Pt, Ni, Ti, V, W, Cr, Al, Cu, Zn, Sn, and In.

In a case where the anode electrode 110 has a laminated structure, the anode electrode 110 is constituted by a material such as, for example, Ti/Au, Ti/Al, Ti/Al/Au, Ti/Pt/Au, Ni/Au, Ni/Au/Pt, Ni/Pt, Pd/Pt, or Ag/Pd.

As an example, a portion of the anode electrode 110 covering the second region A2 is electrically connected to the anode side (positive electrode side) of the laser driver including the driver IC.

### (First and Second Recess Portions)

A first recess portion R1 is defined by two mesas M adjacent to each other among the mesas M of the plurality of light emitting units LEP (see Figs. 1 and 2).

The mesa M (mesa M closest to the -Y side) adjacent to the second region A2 on the -Y side among the mesas M of the plurality of light emitting units LEP and the second region A2 on the -Y side define the second recess portion R2 on the -Y side (see Figs. 1 and 3).

Similarly, the mesa M (mesa M closest to the +Y side) adjacent to the second region A2 on the +Y side among the mesas M of the plurality of light emitting units LEP and the second region A2 on the +Y side define the second recess portion R2 on the +Y side (see Fig. 3).

Hereinafter, the mesa M adjacent to the second region A2 (for example, the mesa M closest to the -Y side and the mesa M closest to the +Y side) is collectively referred to as "outermost peripheral mesas".

As an example, each of the first and second recess portions R1 and R2 has a mortar shape (shape that becomes deeper toward the central portion).

The depth dimension H2 of the second recess portion R2 is larger than the depth dimension H1 of the first recess portion R1.

The depth dimension H1 of the first recess portion R1 is a distance between a portion (for example, a central portion) of the bottom surface of the first recess portion R1 closest to the one surface 100a of the substrate 100 (closest to the -Z side) and the upper surface (surface on the +Z side) of each mesa M.

The bottom surface of the first recess portion R1 is located on the opposite side (+Z side) to the one surface 100a side (-Z side) of the other surface 100b (+Z side surface) of the substrate 100.

More specifically, the bottom surface of the first recess portion R1 is located in the first multilayer film reflector 102.

The depth dimension H2 of the second recess portion R2 is a distance between a portion (for example, a central portion) of the bottom surface of the second recess portion R2 closest to the one surface 100a of the substrate 100 (closest to the -Z side) and the upper surface (surface on the +Z side) of each mesa M.

The bottom surface of the second recess portion R2 is located on the opposite side (+Z side) to the one surface 100a side (-Z side) of the other surface 100b (+Z side surface) of the substrate 100.

More specifically, the bottom surface of the second recess portion R2 is located at a position below (-Z side) the bottom surface of the first recess portion R1 in the first multilayer film reflector 102.

The upper surface of each mesa M and the upper surface of each protruding portion PP are substantially flush. That is, the open ends of the first and second recess portions R1 and R2 are substantially flush (located on the same plane).

Here, in a cross section (for example, a YZ cross section illustrated in Fig. 1) obtained by cutting the two mesas M and the second region A2 adjacent to each other in the first region A1 together, the width of the second recess portion R2 is larger than the width of the first recess portion R1. Note that, in the cross section, the widths of the first and second recess portions R1 and R2 may be the same, or the width of the first recess portion R1 may be larger than the width of the second recess portion R2.

The widths of the first and second recess portions R1 and R2 are, for example, several to several tens µm.

Here, as illustrated in Fig. 3, in the mesas M other than the outermost peripheral mesas and excluding the mesas M on the most +X side and the most -X side, mesas M are present adjacent to any of the +X side, the - X side, the +Y side, and the -Y side (mesas M are present adjacent in four directions). In this case, in the mesas M other than the outermost peripheral mesas, the current flowing in from the anode electrode 110 flows toward the cathode electrode 111 along the height direction (Z-axis direction) due to the influence of the adjacent mesa M.

In the mesas M other than the outermost peripheral mesas and closest to the +X side or the -X side, a separation groove ST is present on the +X side or the -X side, and mesas M are present adjacent to the three sides of the +Y side and the -Y side and the +X side or the -X side (mesas M are present adjacent to the three sides, and a separation groove ST is present on one side). In this case, in the mesas M other than the outermost peripheral mesas, the current flowing in from the anode electrode 110 flows toward the cathode electrode 111 along the height direction (Z-axis direction).

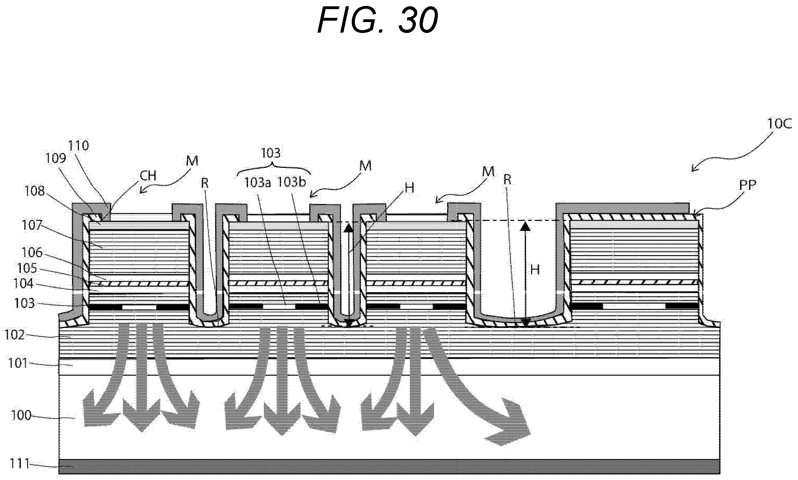

In the outermost peripheral mesas, the adjacent mesa M does not exist on the adjacent second region A2 side. In this case, in the outermost peripheral mesas, the current flowing in from the anode electrode 110 tends to spread from the direction along the height direction (Z-axis direction) to the second region A2 side along the in-plane direction (XY plane), and thus the electrical resistance may be lower than that of the mesas M other than the outermost peripheral mesas (see Fig. 30). In this case, the current concentrates on the outermost peripheral mesas, and there is a concern that the variation in the light emission intensity between the outermost peripheral mesas and the other mesas M increases.

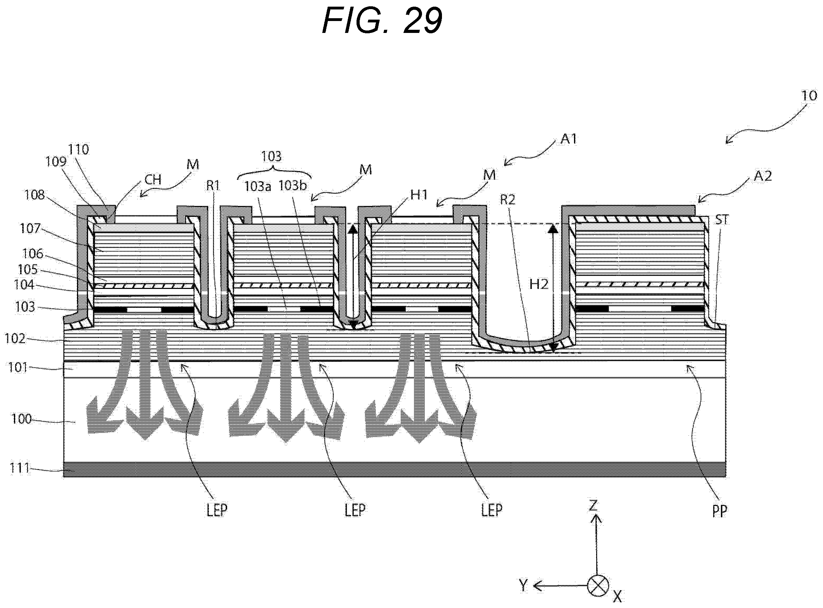

Therefore, in the present embodiment, as described above, by making the depth dimension of the second recess portion R2 larger than the depth dimension of the first recess portion R1, the path of the current to the second region A2 side is narrowed, and the current flowing through the outermost peripheral mesas is suppressed from spreading to the second region A2 side (see Fig. 29). As a result, since the electric resistance of the outermost peripheral mesas is suppressed from lowering, the current is suppressed from concentrating on the outermost peripheral mesas, and furthermore, the variation in the light emission intensity between the outermost peripheral mesas and the other mesas M can be reduced. More specifically, it is possible to suppress the light emission intensity of the outermost peripheral mesas from being higher than the light emission intensity of the other mesas M.

Note that the degree of reduction of the difference (resistance difference) in electrical resistance between the outermost peripheral mesas and the mesas M other than the outermost peripheral mesas can be set by the difference (H2 - H1) in depth dimension between the first and second recess portions R1 and R2.

Basically, as H2 - H1 increases, the degree of reduction of the resistance difference increases. Conversely, as H2 - H1 decreases, the degree of reduction of the resistance difference decreases.

Therefore, in a case where the resistance difference is small, for example, in a case where the mesa pitch is relatively large (for example, 30 to 50 µm), it is preferable to set H2 - H1 relatively small, and in a case where the resistance difference is large, for example, in a case where the mesa pitch is relatively small (for example, 10 to 30 µm), it is preferable to set H2 - H1 relatively large.

Therefore, the difference H2 - H1 between the depth dimensions of the first and second recess portions R1 and R2 may be set on the basis of the interval (mesa pitch) between the centers of two mesas M adjacent to each other.

In this case, the difference H2 - H1 between the depth dimensions of the first and second recess portions R1 and R2 is preferably set larger as the interval between the centers of two mesas M adjacent to each other is narrower.

### (Separation Groove)

A separation groove ST for element separation is formed at an end portion of each of the second regions A2 on the opposite side to the first region A1 side and at an end portion of the first region A1 on the +X side and the -X side (see Figs. 1 and 3).

As an example, the bottom surface of the separation groove ST is located in the first multilayer film reflector 102.

### 2. <Operation of Surface Emitting Laser Element According to Embodiment of Present Technology>

In each light emitting unit LEP of the surface emitting laser element 10, when a current is injected into the active layer 105 from the anode side of the laser driver via the anode electrode 110, the contact layer 108, the second multilayer film reflector 107, and the second cladding layer 106, the active layer 105 emits light, and the light is amplified by the active layer 105 between the first and second multilayer film reflectors 102 and 107 and reciprocates while being narrowed by the oxidation confinement layer 103, and is emitted as laser light to the back surface side of the substrate 100 when oscillation conditions are satisfied. The current injected into the active layer 105 flows out to the cathode side of the laser driver via the first cladding layer 104, the oxidation confinement layer 103, the first multilayer film reflector 102, and the cathode electrode 111.

### 3. <First Example of Method for Manufacturing Surface Emitting Laser Element According to Embodiment of Present Technology>

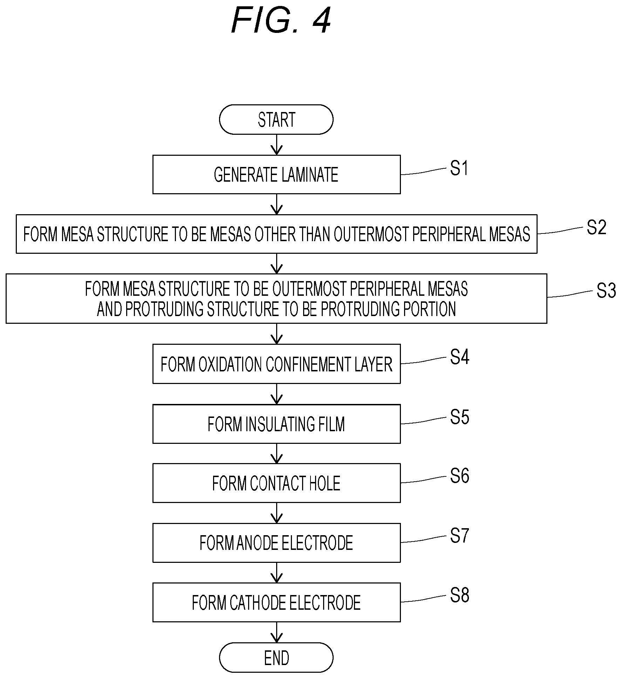

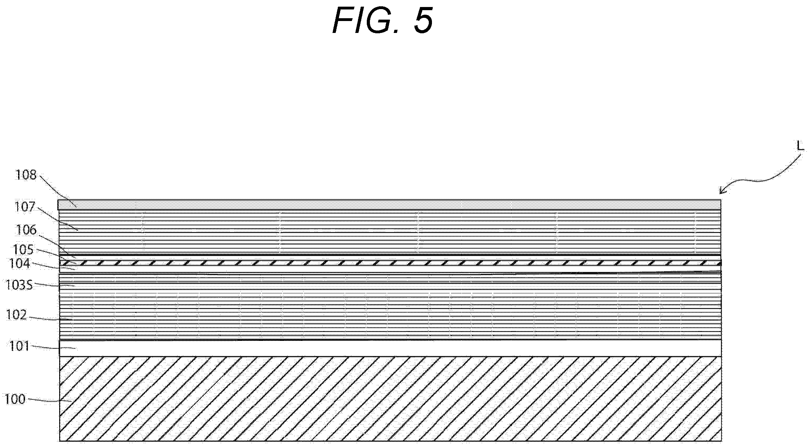

Hereinafter, a first example of a method for manufacturing the surface emitting laser element 10 according to one embodiment will be described with reference to the flowchart of Fig. 4 and the cross-sectional views of Figs. 5 to 16.

Here, as an example, a plurality of surface emitting laser elements 10 is simultaneously generated on one wafer which is a base material of the substrate 100 by a semiconductor manufacturing method using a semiconductor manufacturing apparatus. Next, a plurality of surface emitting laser elements 10 that is integrated to be one piece is separated from each other by dicing to obtain a plurality of chip-shaped surface emitting laser elements 10.

In the first step S1, a laminate L is generated. Specifically, using a chemical vapor deposition (CVD) method, for example, a metal organic chemical vapor deposition (MOCVD) method, as illustrated in Fig. 5, the first multilayer film reflector 102 including the spacer layer 101 and a selected oxide layer 103S constituted by AlAs, the first cladding layer 104, the active layer 105, the second cladding layer 106, the second multilayer film reflector 107, and the contact layer 108 are laminated in this order on the substrate 100 to generate the laminate L.

In the next step S2, the mesa structure MS to be the mesas M other than the outermost peripheral mesas is formed.

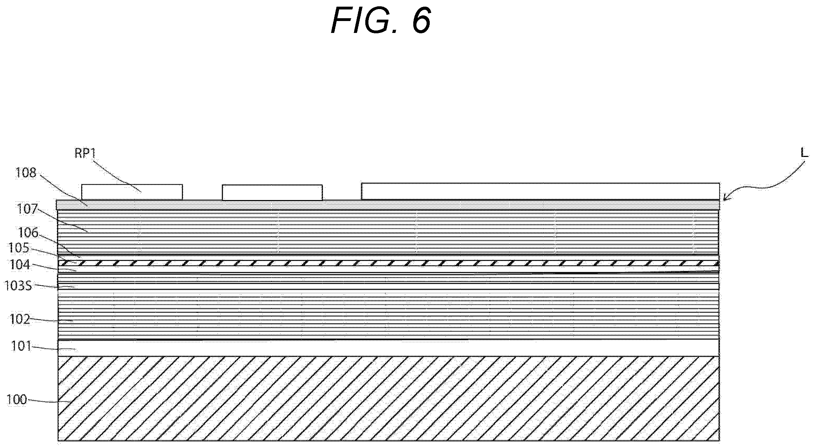

Specifically, first, a resist pattern RP1 for forming the mesa structure MS to be the mesas M other than the outermost peripheral mesas on the contact layer 108 of the laminate L is generated (see Fig. 6).

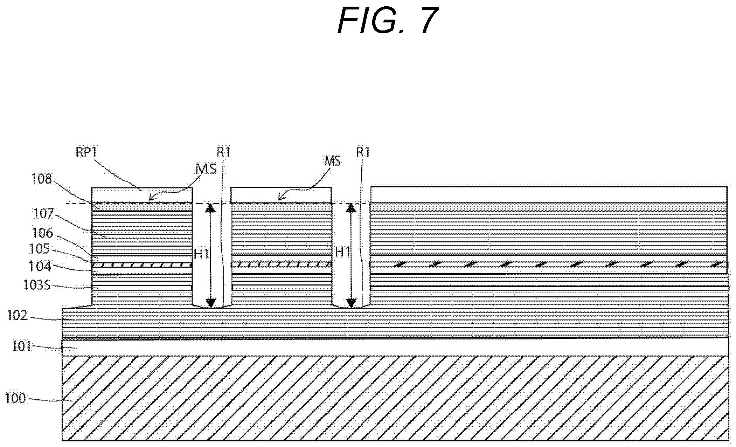

Next, the laminate L is etched by dry etching or wet etching using the resist pattern RP1 as a mask to form a mesa structure MS (see Fig. 7). Here, etching is performed until at least the side surface of the selected oxide layer 103S is exposed (until the etching bottom surface serving as the bottom surface of the first recess portion R1 is located below the selected oxide layer 103S in the first multilayer film reflector 102). By forming the two mesa structures MS adjacent to each other, the first recess portion R1 having the depth dimension H1 is formed.

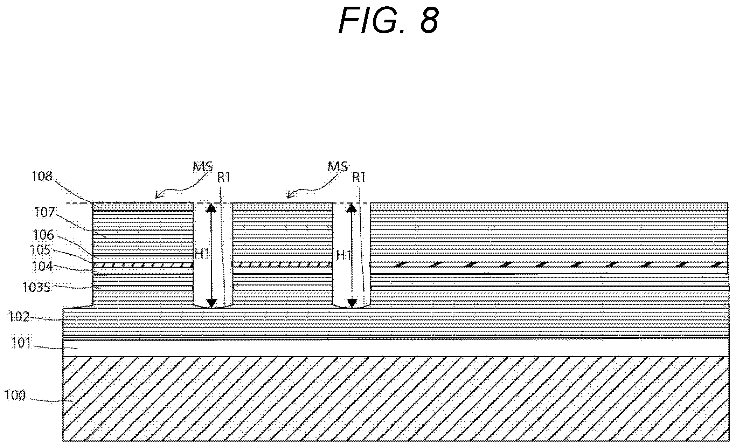

Finally, the resist pattern RP1 is etched and removed by dry etching or wet etching (see Fig. 8).

In the next step S3, the mesa structure MS to be the outermost peripheral mesas and the protruding structure PS to be the protruding portion PP are formed.

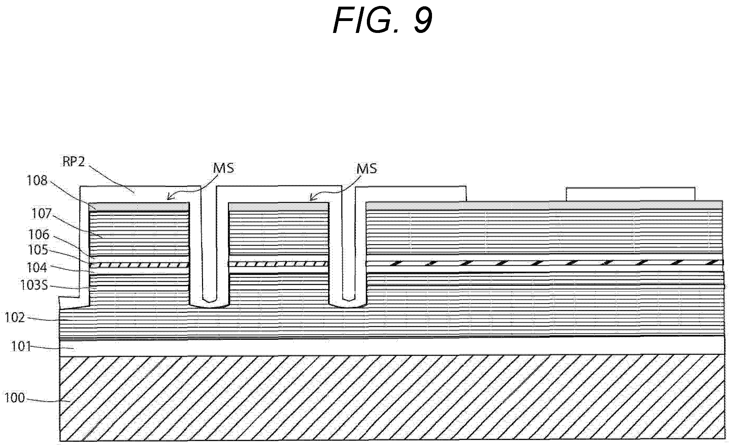

Specifically, first, a resist pattern RP2 for forming the mesa structure MS to be the outermost peripheral mesas and the protruding structure PS to be the protruding portion PP is formed on the laminate on which the mesa structure MS is formed (see Fig. 9).

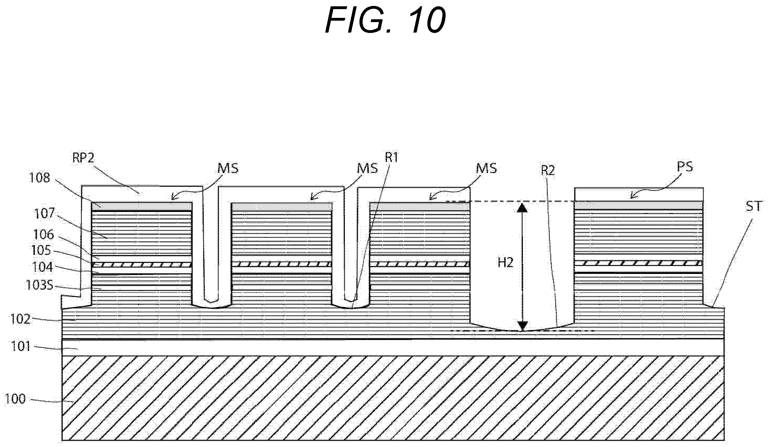

Next, the laminate is etched by dry etching or wet etching using the resist pattern RP2 as a mask to form the mesa structure MS to be the outermost peripheral mesas and the protruding structure PS to be the protruding portion PP (see Fig. 10). Here, etching is performed until the etching bottom surface serving as the bottom surface of the second recess portion R2 is located below the bottom surface of the first recess portion R1 in the first multilayer film reflector 102. By forming the mesa structure MS to be the outermost peripheral mesas and the protruding structure PS to be the protruding portion PP, the second recess portion R2 and the separation groove ST having the depth dimension H2 are formed.

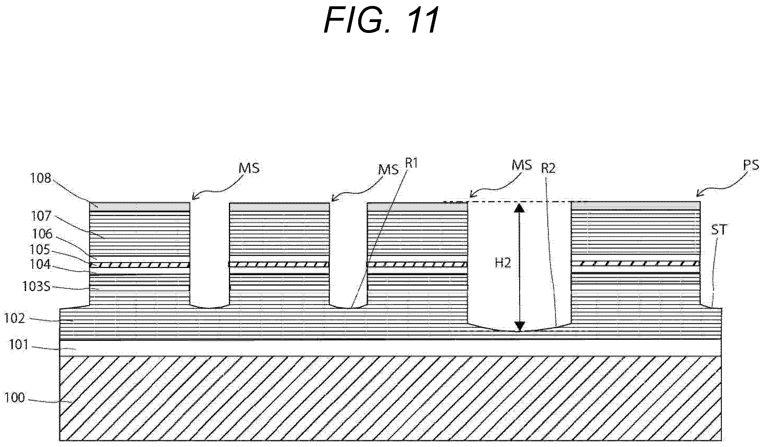

Finally, the resist pattern RP2 is etched and removed by dry etching or wet etching (see Fig. 11).

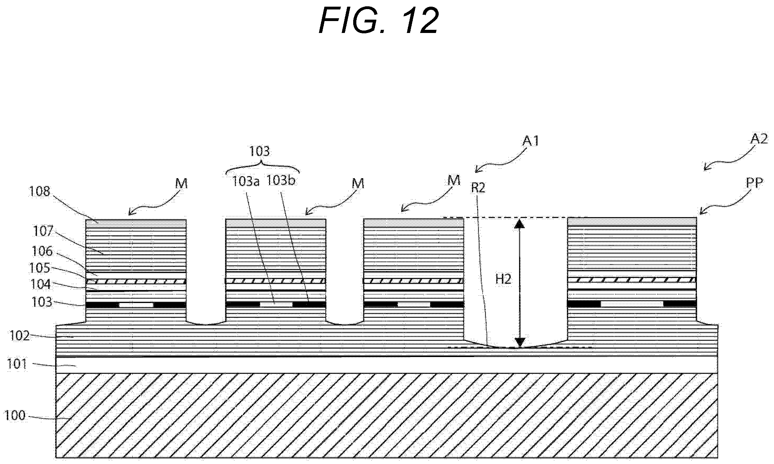

In the next step S4, the oxidation confinement layer 103 is formed. Specifically, the peripheral portion of the selected oxide layer 103S of the mesa structure MS (see Fig. 11) is oxidized to generate the oxidation confinement layer 103 (see Fig. 12). More specifically, the mesa structure MS is exposed to a water vapor atmosphere, and the selected oxide layer 103S is oxidized from the side surface (Al in AlAs is selectively oxidized) to form the oxidation confinement layer 103 in which the non-oxidized region 103a is surrounded by the oxidized region 103b. At this time, the selected oxide layer 103S having the protruding structure PS is similarly oxidized. As a result, the mesa structure MS becomes the mesa M to form the first region A1, and the protruding structure PS becomes the protruding portion PP to form the second region A2.

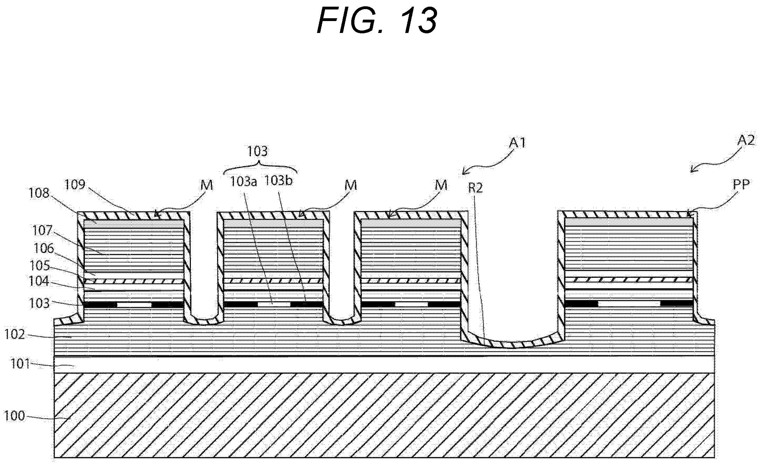

In the next step S5, the insulating film 109 is formed (see Fig. 13). Specifically, the insulating film 109 is formed on the laminate on which the first and second regions A1 and A2 are formed by a vapor deposition method, a sputtering method, or the like.

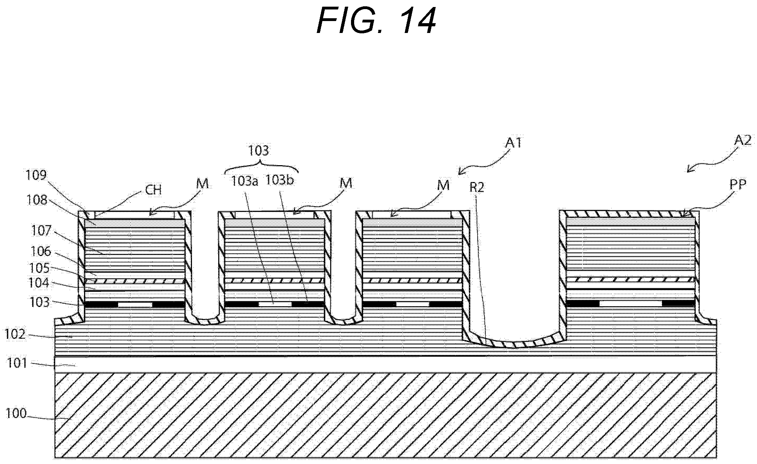

In the next step S6, the contact hole CH is formed (see Fig. 14). Specifically, the insulating film 109 covering the top portion of the mesa M is etched and removed by dry etching or wet etching. As a result, the contact hole CH is formed, and the top portion (contact layer 108) of the mesa M is exposed.

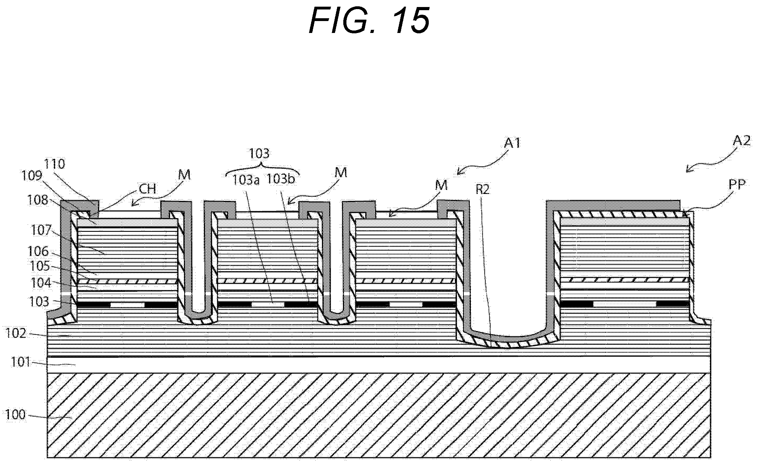

In the next step S7, the anode electrode 110 is formed. Specifically, an electrode material of the anode electrode 110 is formed on the insulating film 109 in which the contact hole CH is opened by a vapor deposition method, a sputtering method, or the like, and patterning is performed by a lift-off method, for example (see Fig. 15).

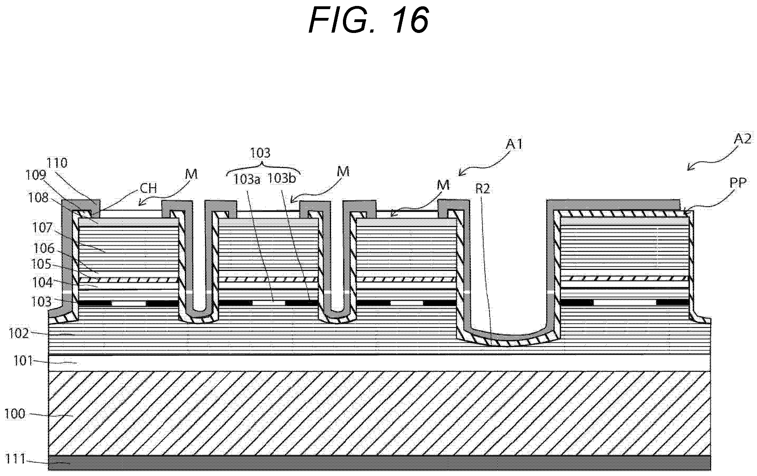

In the final step S8, the cathode electrode 111 is formed (see Fig. 16). Specifically, after the back surface of the substrate 100 is polished to be thinned, the electrode material of the cathode electrode 111 is deposited in a solid form over substantially the entire region of the back surface of the substrate 100 by a vapor deposition method or a sputtering method.

Thereafter, processing such as annealing is performed to form a plurality of surface emitting laser elements 10 on one wafer. Thereafter, the plurality of surface emitting laser elements 10 is separated for each element by dicing along the separation groove ST to obtain a plurality of chip-shaped surface emitting laser elements 10.

### 4. <Second Example of Method for Manufacturing Surface Emitting Laser Element According to Embodiment of Present Technology>

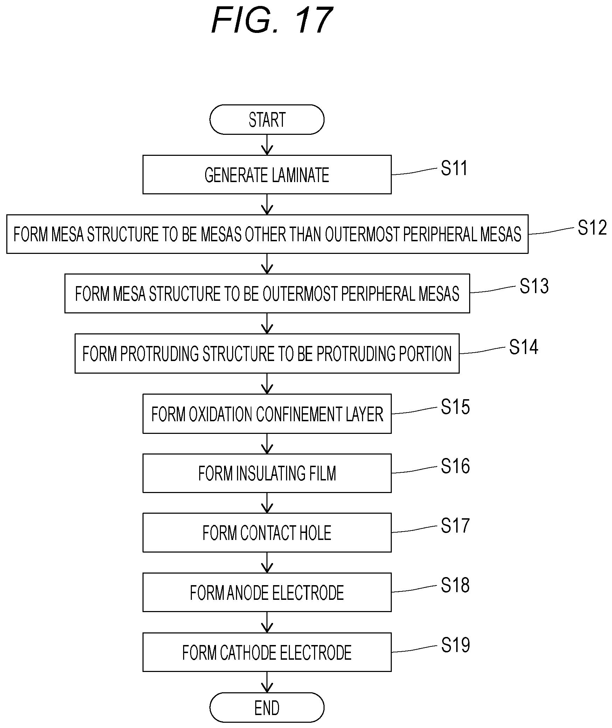

Hereinafter, a second example of the method for manufacturing the surface emitting laser element 10 according to one embodiment will be described with reference to the flowchart of Fig. 17, and cross-sectional views of Figs. 5 to 8, 11 to 16, and 18 to 22.

Here, as an example, a plurality of surface emitting laser elements 10 is simultaneously generated on one wafer which is a base material of the substrate 100 by a semiconductor manufacturing method using a semiconductor manufacturing apparatus. Next, a plurality of surface emitting laser elements 10 that is integrated to be one piece is separated from each other by dicing to obtain a plurality of chip-shaped surface emitting laser elements 10.

In the first step S11, a laminate L is generated. Specifically, using a chemical vapor deposition (CVD) method, for example, a metal organic chemical vapor deposition (MOCVD) method, as illustrated in Fig. 5, the first multilayer film reflector 102 including the spacer layer 101 and a selected oxide layer 103S constituted by AlAs, the first cladding layer 104, the active layer 105, the second cladding layer 106, the second multilayer film reflector 107, and the contact layer 108 are laminated in this order on the substrate 100 to generate the laminate L.

In the next step S12, the mesa structure MS to be the mesas M other than the outermost peripheral mesas is formed.

Specifically, first, a resist pattern RP1 for forming the mesa structure MS to be the mesas M other than the outermost peripheral mesas on the contact layer 108 of the laminate L is generated (see Fig. 6).

Next, the laminate L is etched by dry etching or wet etching using the resist pattern RP1 as a mask to form a mesa structure MS (see Fig. 7). Here, etching is performed until at least the side surface of the selected oxide layer 103S is exposed (until the etching bottom surface serving as the bottom surface of the first recess portion R1 is located below the selected oxide layer 103S in the first multilayer film reflector 102). By forming the two mesa structures MS adjacent to each other, the first recess portion R1 having the depth dimension H1 is formed.

Finally, the resist pattern RP1 is etched and removed by dry etching or wet etching (see Fig. 8).

In the next step S13, the mesa structure MS to be the outermost peripheral mesas is formed.

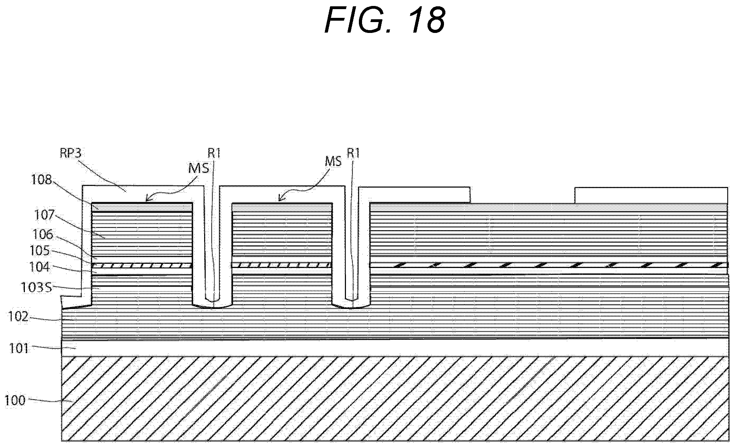

Specifically, first, a resist pattern RP3 for forming the mesa structure MS to be the outermost peripheral mesas is formed on the laminate on which the mesa structure MS is formed (see Fig. 18).

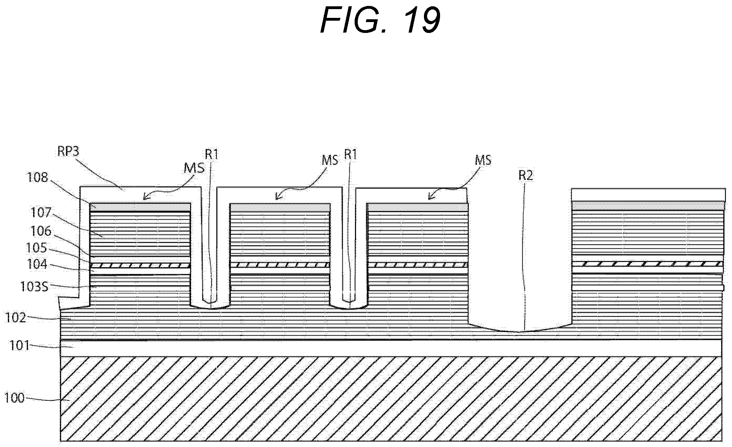

Next, the laminate is etched by dry etching or wet etching using the resist pattern RP3 as a mask to form a mesa structure MS to be the outermost peripheral mesas (see Fig. 19). Here, etching is performed until the etching bottom surface serving as the bottom surface of the second recess portion R2 is located below the bottom surface of the first recess portion R1 in the first multilayer film reflector 102. By forming the mesa structure MS serving as the outermost peripheral mesas, the second recess portion R2 having the depth dimension H2 is formed.

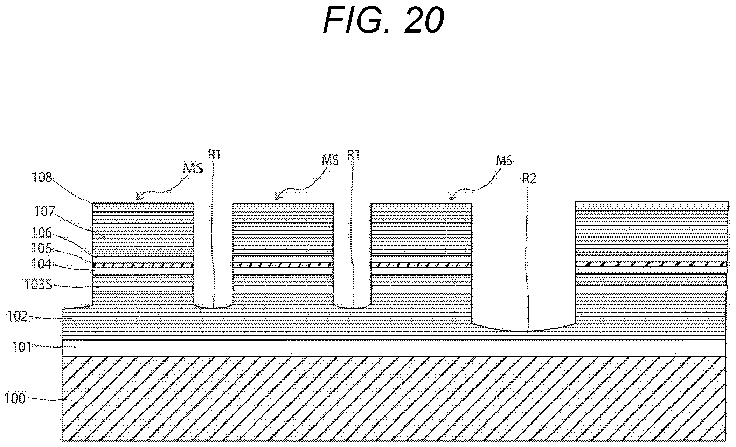

Finally, the resist pattern RP3 is etched and removed by dry etching or wet etching (see Fig. 20).

In the next step S14, the protruding structure PS to be the protruding portion PP is formed.

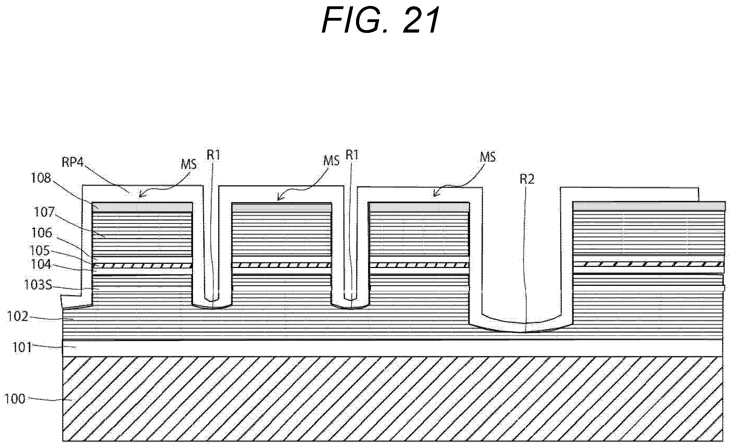

Specifically, first, a resist pattern RP4 for forming the protruding structure PS to be the protruding portion PP is formed on the laminate on which the mesa structure MS is formed (see Fig. 21).

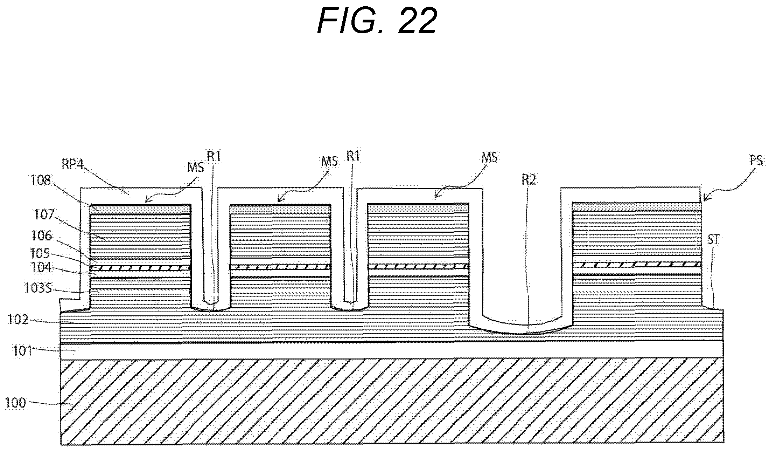

Next, the laminate is etched by dry etching or wet etching using the resist pattern RP4 as a mask to form the protruding structure PS to be the protruding portion PP (see Fig. 22). Here, etching is performed until the etching bottom surface serving as the bottom surface of the separation groove ST is located below the selected oxide layer 103S in the first multilayer film reflector 102. By forming the protruding structure PS serving as the protruding portion PP, the separation groove ST is formed.

Finally, the resist pattern RP4 is etched and removed by dry etching or wet etching (see Fig. 11).

In the next step S15, the oxidation confinement layer 103 is formed. Specifically, the peripheral portion of the selected oxide layer 103S of the mesa structure MS (see 11) is oxidized to generate the oxidation confinement layer 103 (see Fig. 12). More specifically, the mesa structure MS is exposed to a water vapor atmosphere, and the selected oxide layer 103S is oxidized from the side surface (Al in AlAs is selectively oxidized) to form the oxidation confinement layer 103 in which the non-oxidized region 103a is surrounded by the oxidized region 103b. At this time, the selected oxide layer 103S having the protruding structure PS is similarly oxidized. As a result, the mesa structure MS becomes the mesa M to form the first region A1, and the protruding structure PS becomes the protruding portion PP to form the second region A2.

In the next step S16, the insulating film 109 is formed (see Fig. 13). Specifically, the insulating film 109 is formed on the laminate on which the first and second regions A1 and A2 are formed by a vapor deposition method, a sputtering method, or the like.

In the next step S17, the contact hole CH is formed (see Fig. 14). Specifically, the insulating film 109 covering the top portion of the mesa M is etched and removed by dry etching or wet etching. As a result, the contact hole CH is formed, and the top portion (contact layer 108) of the mesa M is exposed.

In the next step S18, the anode electrode 110 is formed. Specifically, an electrode material of the anode electrode 110 is formed on the insulating film 109 in which the contact hole CH is opened by a vapor deposition method, a sputtering method, or the like, and patterning is performed by a lift-off method, for example (see Fig. 15).

In the final step S19, the cathode electrode 111 is formed (see Fig. 16). Specifically, after the back surface of the substrate 100 is polished to be thinned, the electrode material of the cathode electrode 111 is deposited in a solid form over substantially the entire region of the back surface of the substrate 100 by a vapor deposition method or a sputtering method.

Thereafter, processing such as annealing is performed to form a plurality of surface emitting laser elements 10 on one wafer. Thereafter, the plurality of surface emitting laser elements 10 is separated for each element by dicing along the separation groove ST to obtain a plurality of chip-shaped surface emitting laser elements 10.

### 5. <Third Example of Method for Manufacturing Surface Emitting Laser Element According to Embodiment of Present Technology>

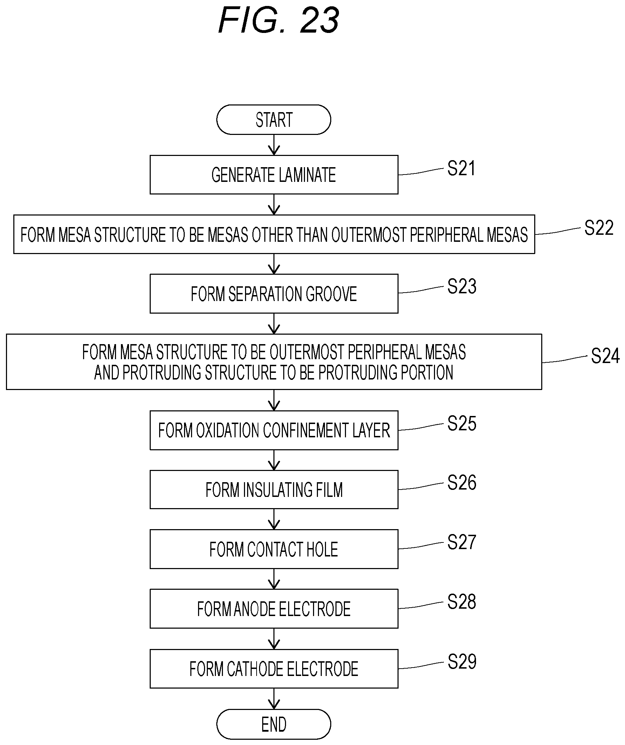

Hereinafter, a third example of the method for manufacturing the surface emitting laser element 10 according to one embodiment will be described with reference to the flowchart of Fig. 23, and cross-sectional views of Figs. 5 to 8, 11 to 16, and 24 to 28.

Here, as an example, a plurality of surface emitting laser elements 10 is simultaneously generated on one wafer which is a base material of the substrate 100 by a semiconductor manufacturing method using a semiconductor manufacturing apparatus. Next, a plurality of surface emitting laser elements 10 that is integrated to be one piece is separated from each other by dicing to obtain a plurality of chip-shaped surface emitting laser elements 10.

In the first step S21, a laminate L is generated. Specifically, using a chemical vapor deposition (CVD) method, for example, a metal organic chemical vapor deposition (MOCVD) method, as illustrated in Fig. 5, the first multilayer film reflector 102 including the spacer layer 101 and a selected oxide layer 103S constituted by AlAs, the first cladding layer 104, the active layer 105, the second cladding layer 106, the second multilayer film reflector 107, and the contact layer 108 are laminated in this order on the substrate 100 to generate the laminate L.

In the next step S22, the mesa structure MS to be the mesas M other than the outermost peripheral mesas is formed.

Specifically, first, a resist pattern RP1 for forming the mesa structure MS to be the mesas M other than the outermost peripheral mesas on the contact layer 108 of the laminate L is generated (see Fig. 6).

Next, the laminate L is etched by dry etching or wet etching using the resist pattern RP1 as a mask to form a mesa structure MS (see Fig. 7). Here, etching is performed until at least the side surface of the selected oxide layer 103S is exposed (until the etching bottom surface serving as the bottom surface of the first recess portion R1 is located below the selected oxide layer 103S in the first multilayer film reflector 102). By forming the two mesa structures MS adjacent to each other, the first recess portion R1 having the depth dimension H1 is formed.

Finally, the resist pattern RP1 is etched and removed by dry etching or wet etching (see Fig. 8).

In the next step S23, the separation groove ST is formed.

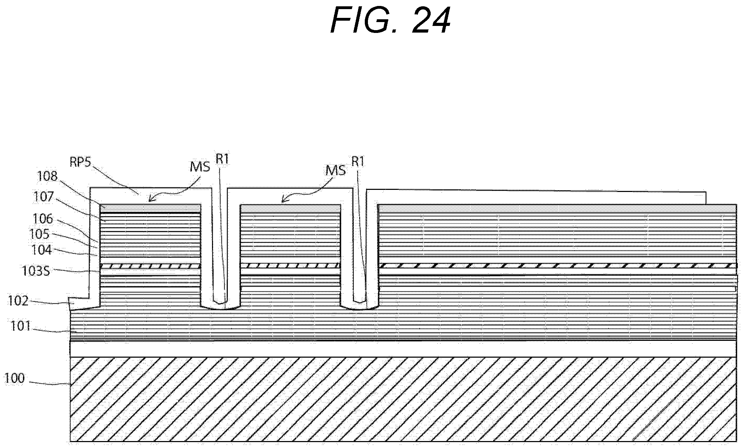

Specifically, first, a resist pattern RP5 for forming the separation groove ST is formed on the laminate on which the mesa structure MS is formed (see Fig. 24).

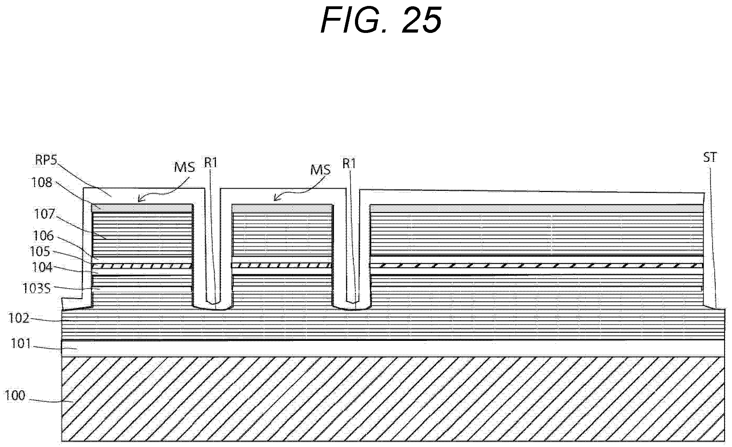

Next, the laminate is etched by dry etching or wet etching using the resist pattern RP5 as a mask to form the separation groove ST (see Fig. 25). Here, etching is performed until the etching bottom surface serving as the bottom surface of the separation groove ST is located below the selected oxide layer 103S in the first multilayer film reflector 102.

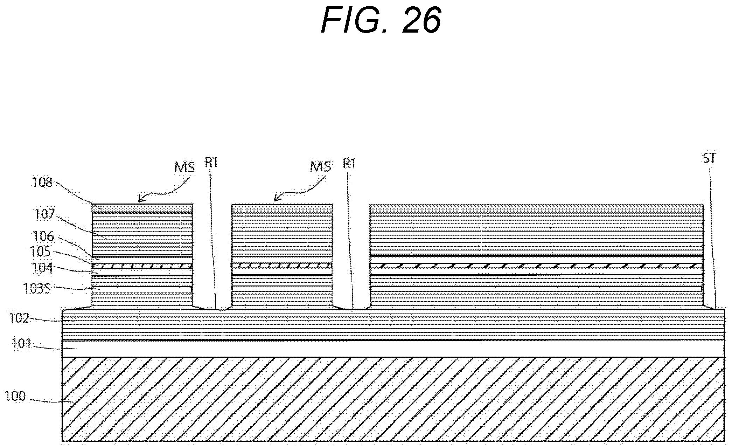

Finally, the resist pattern RP5 is etched and removed by dry etching or wet etching (see Fig. 26).

In the next step S24, the mesa structure MS to be the outermost peripheral mesas and the protruding structure PS to be the protruding portion PP are formed.

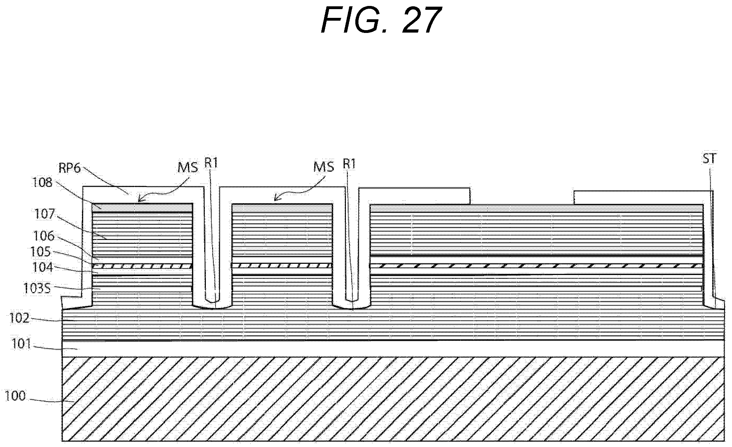

Specifically, first, a resist pattern RP6 for forming the mesa structure MS to be the outermost peripheral mesas and the protruding structure PS to be the protruding portion PP is formed on the laminate in which the mesa structure MS and the separation groove ST are formed (see Fig. 27).

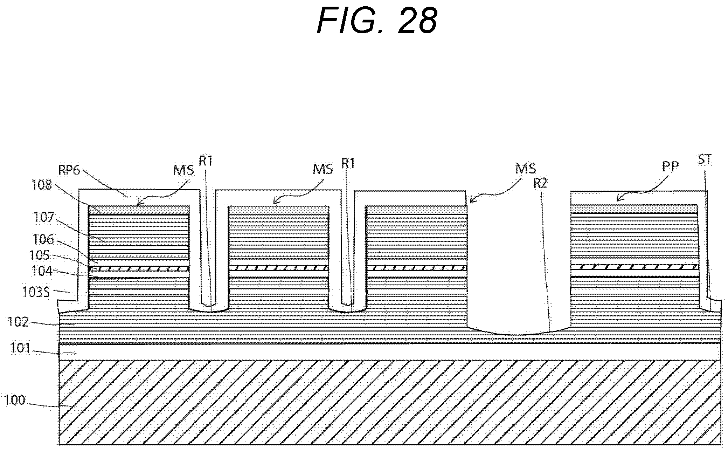

Next, the laminate is etched by dry etching or wet etching using the resist pattern RP6 as a mask to form the mesa structure MS to be the outermost peripheral mesas and the protruding structure PS to be the protruding portion PP (see Fig. 28). Here, etching is performed until the etching bottom surface serving as the bottom surface of the second recess portion R2 is located below the bottom surface of the first recess portion R1 in the first multilayer film reflector 102.

Finally, the resist pattern RP6 is etched and removed by dry etching or wet etching (see Fig. 11).

In the next step S25, the oxidation confinement layer 103 is formed. Specifically, the peripheral portion of the selected oxide layer 103S of the mesa structure MS (see Fig. 11) is oxidized to generate the oxidation confinement layer 103 (see Fig. 12). More specifically, the mesa structure MS is exposed to a water vapor atmosphere, and the selected oxide layer 103S is oxidized from the side surface (Al in AlAs is selectively oxidized) to form the oxidation confinement layer 103 in which the non-oxidized region 103a is surrounded by the oxidized region 103b. At this time, the selected oxide layer 103S having the protruding structure PS is similarly oxidized. As a result, the mesa structure MS becomes the mesa M to form the first region A1, and the protruding structure PS becomes the protruding portion PP to form the second region A2.

In the next step S26, the insulating film 109 is formed (see Fig. 13). Specifically, the insulating film 109 is formed on the laminate on which the first and second regions A1 and A2 are formed by a vapor deposition method, a sputtering method, or the like.

In the next step S27, the contact hole CH is formed (see Fig. 14). Specifically, the insulating film 109 covering the top portion of the mesa M is etched and removed by dry etching or wet etching. As a result, the contact hole CH is formed, and the top portion (contact layer 108) of the mesa M is exposed.

In the next step S28, the anode electrode 110 is formed. Specifically, an electrode material of the anode electrode 110 is formed on the insulating film 109 in which the contact hole CH is opened by a vapor deposition method, a sputtering method, or the like, and patterning is performed by a lift-off method, for example (see Fig. 15).

In the final step S29, the cathode electrode 111 is formed (see Fig. 16). Specifically, after the back surface of the substrate 100 is polished to be thinned, the electrode material of the cathode electrode 111 is deposited in a solid form over substantially the entire region of the back surface of the substrate 100 by a vapor deposition method or a sputtering method.

Thereafter, processing such as annealing is performed to form a plurality of surface emitting laser elements 10 on one wafer. Thereafter, the plurality of surface emitting laser elements 10 is separated for each element by dicing along the separation groove ST to obtain a plurality of chip-shaped surface emitting laser elements 10.

In each of the first to third examples of the method for manufacturing the surface emitting laser element 10 described above, after the mesa structure MS to be the mesas M other than the outermost peripheral mesas is formed by etching, the protruding structure PS to be the protruding portion PP, the second recess portion R2, and the separation groove ST are formed by etching, but the present invention is not limited thereto. For example, the mesa structure MS to be the mesas M other than the outermost peripheral mesas, the protruding structure PS to be the protruding portion PP, the second recess portion R2, and the separation groove ST may be simultaneously formed by etching. However, when the first recess portion R1, the second recess portion R2, and the separation groove ST are formed by separate etching as much as possible (preferably all of them), the accuracy of each etching depth (position accuracy of the bottom surface) can be enhanced.

### 6. <Effects of Surface Emitting Laser Element According to Embodiment of Present Technology and Manufacturing Method Thereof>

Hereinafter, effects of a surface emitting laser element 10 and a manufacturing method thereof according to one embodiment of the present technology will be described.

A surface emitting laser element 10 according to one embodiment includes a substrate 100, a cathode electrode 111 provided on one surface 100a (back surface) of the substrate 100, a first region A1 provided on the side of the one surface 100a opposite to the cathode electrode 111 side and in which a plurality of light emitting units LEP including mesas M is arranged, and a second region A2 arranged around the first region A1 on the side of the one surface 100a opposite to the cathode electrode 111 side, and is configured such that the depth dimension H2 of the second recess portion R2 defined by the mesas M (outermost peripheral mesas) adjacent to the second region A2 among the mesas M of the plurality of light emitting units LEP and the second region A2 is larger than the depth dimension H1 of the first recess portion R1 defined by two mesas adjacent mesas M among the mesas M of the plurality of light emitting units LEP.

In this case, since the current flowing through the outermost peripheral mesas is suppressed from spreading to the second region A2 side, the decrease in the electrical resistance of the outermost peripheral mesas is suppressed, and furthermore, the current is suppressed from concentrating on the outermost peripheral mesas (see Fig. 29).

As a result, according to the surface emitting laser element 10, it is possible to reduce the variation in the light emission intensity between the light emitting units LEP adjacent to the second region A2 and light emitting units LEP other than the light emitting units LEP.

On the other hand, in a surface emitting laser element 10C of a comparative example illustrated in Fig. 30, the depth dimension H of the recess portion R defined by two mesas M adjacent to each other among the mesas M of the plurality of light emitting units is the same as the depth dimension H of the recess portion R defined by the mesas M (outermost peripheral mesas) adjacent to the protruding portion PP among the mesas M of the plurality of light emitting units and the protruding portion PP. In this case, the current flowing through the outermost peripheral mesas cannot be suppressed from spreading to the protruding portion PP side, the electrical resistance of the outermost peripheral mesas decreases, and the current concentrates on the outermost peripheral mesas. As a result, the variation in the light emission intensity between the light emitting units having the mesas adjacent to the protruding portion PP and light emitting units other than the light emitting units cannot be reduced. This also applies to the surface emitting laser element described in Patent Document 1.

The cathode electrode 111 is a common electrode provided in common for the plurality of light emitting units LEP. In this case, since the current flowing through each mesa M flows to the cathode electrode 111 side (back surface side of the substrate 100), the above configuration of the surface emitting laser element 10 is particularly effective.

The bottom surface of the second recess portion R2 is located at a position closer to the one surface 100a of the substrate 100 than the bottom surface of the first recess portion R1 in the direction perpendicular to the substrate 100 (Z-axis direction). As a result, it is possible to reliably reduce the variation in the above-described light emission intensity.

Further, the opening ends of the first and second recess portions R1 and R2 are substantially flush. Thus, the first and second recess portions R1 and R2 can be formed by etching the laminate L generated by one crystal growth (for example, epitaxial growth).

The surface emitting laser element 10 further includes an anode electrode 110 provided in contact with the top portion of at least one mesa M adjacent to the second region A2 and the top portion of at least two mesas M not adjacent to the second region A2. In this case, the light emitting units LEP including the respective mesas M are simultaneously driven at the same voltage, but even in this case, the variation in the above-described light emission intensity can be suppressed.

The interval (mesa pitch) between the centers of two mesas M adjacent to each other is preferably 10 µm or more and 50 µm or less. In this case, since the mesa pitch is relatively small, the resistance difference between the outermost peripheral mesas and the other mesas tends to be relatively large, and the configuration of the surface emitting laser element 10 is particularly effective.

A method for manufacturing the surface emitting laser element 10 (first to third examples) includes: a step of laminating a first multilayer film reflector 102, an active layer, and a second multilayer film reflector in this order on a substrate 100 to generate a laminate L; a step of forming a first region A1 in which a plurality of light emitting units LEP including mesas M is arranged and a second region A2 around the first region A1 by etching the laminate L; and a step of forming a cathode electrode 111 on a surface of the substrate 100 opposite to a surface on a side of the first multilayer film reflector 102, in which in the step of forming the first and second regions A1 and A2, the laminate is etched such that a depth dimension of a second recess portion R2 defined by the mesas M adjacent to the second region A2 among the mesas M of the plurality of light emitting units LEP and the second region A2 is larger than a depth dimension of a first recess portion R1 defined by two mesas M adjacent to each other among the mesas M of the plurality of light emitting units LEP.

According to the method for manufacturing the surface emitting laser element 10, it is possible to manufacture the surface emitting laser element capable of reducing the variation in the light emission intensity between the light emitting units LEP adjacent to the second region A2 and light emitting units LEP other than the light emitting units LEP.

In the step of forming the cathode electrode 111, the cathode electrode 111 is formed in, for example, a solid shape in a region corresponding to at least the first and second regions A1 and A2 on the surface of the substrate 100 on the side opposite to the surface on the first multilayer film reflector 102 side. As a result, the cathode electrode 111 common to the plurality of light emitting units LEP can be easily formed.

### 7. <Surface Emitting Laser Element According to Modifications 1 to 9 of Embodiment of Present Technology>

Hereinafter, surface emitting laser elements 10-1 to 10-9 according to Modifications 1 to 9 of one embodiment of the present technology will be described with reference to the drawings.

### (Surface Emitting Laser Element According to Modification 1)

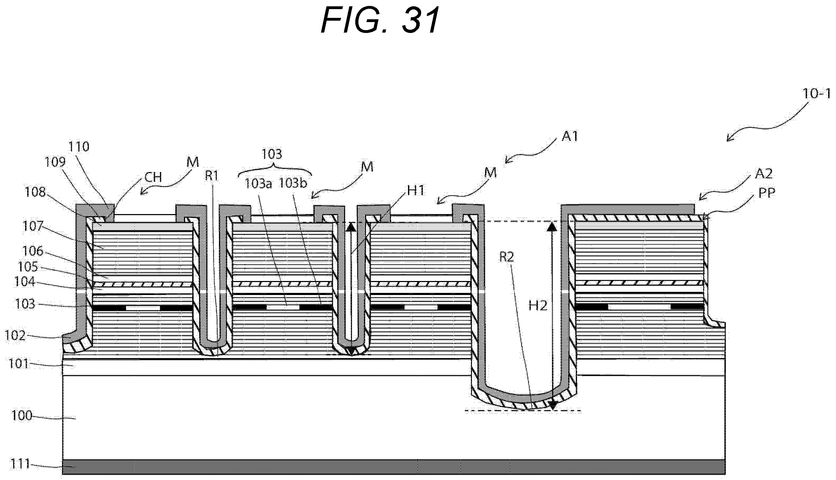

Fig. 31 is a cross-sectional view of a surface emitting laser element 10-1 of Modification 1 (a cross-sectional view corresponding to the cross-sectional view taken along line V-V of Fig. 3 (Fig. 1)).

As illustrated in Fig. 31, the surface emitting laser element 10-1 according to Modification 1 has a similar configuration to the surface emitting laser element 10 of one embodiment except that the bottom surface of the first recess portion R1 is located in the first multilayer film reflector 102 and the bottom surface of the second recess portion R2 is located in the substrate 100.

The surface emitting laser element 10-1 exhibits substantially similar effects to the surface emitting laser element 10 of one embodiment.

Here, the first and second multilayer film reflectors 102 and 107 are designed to have a specific resistance higher than that of the substrate 100 in order to reduce free carrier loss. Therefore, in the surface emitting laser element 10-1, under the condition that the difference (H2 - H1) in depth dimension between the first and second recess portions R1 and R2 is the same, the reduction degree of the difference (resistance difference) in electric resistance between the outermost peripheral mesas and the mesas M other than the outermost peripheral mesas is smaller than that of the surface emitting laser element 10 of one embodiment. However, since the bottom surface of the second recess portion R2 is located in the substrate 100 (since the second recess portion R2 is deep), the effect of suppressing the current from spreading to the second region A2 side is high.

The surface emitting laser element 10-1 can also be manufactured by a manufacturing method similar to the manufacturing method of the surface emitting laser element 10.

### (Surface Emitting Laser Element According to Modification 2)

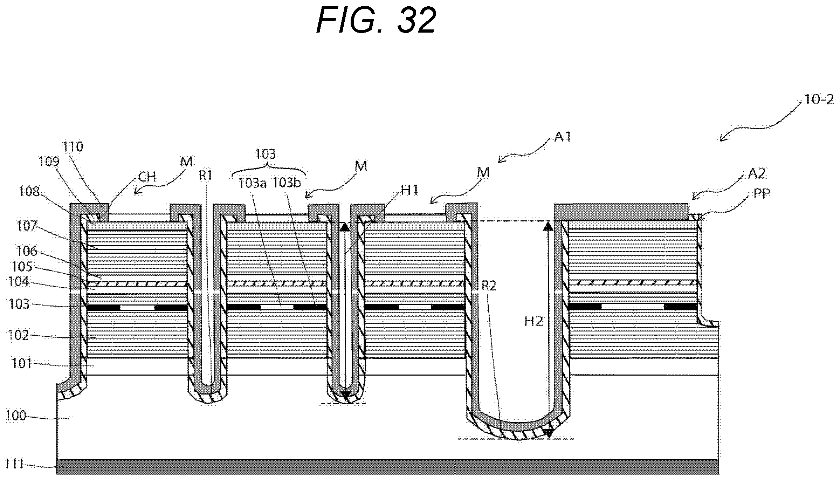

Fig. 32 is a cross-sectional view of a surface emitting laser element 10-2 of Modification 2 (a cross-sectional view corresponding to the cross-sectional view taken along line V-V of Fig. 3 (Fig. 1)).

As illustrated in Fig. 32, the surface emitting laser element 10-2 according to Modification 2 has a similar configuration to the surface emitting laser element 10 of one embodiment except that both the bottom surface of the first recess portion R1 and the bottom surface of the second recess portion R2 are located in the substrate 100.

The surface emitting laser element 10-2 exhibits substantially similar effects to the surface emitting laser element 10 of one embodiment, but under the same condition of H2 - H1, the reduction degree of the resistance difference is smaller than that of the surface emitting laser element 10. However, since the bottom surface of the second recess portion R2 is located in the substrate 100 (since the second recess portion R2 is deep), the effect of suppressing the current from spreading to the second region A2 side is high.

The surface emitting laser element 10-2 can also be manufactured by a manufacturing method similar to the manufacturing method of the surface emitting laser element 10.

### (Surface Emitting Laser Element According to Modification 3)

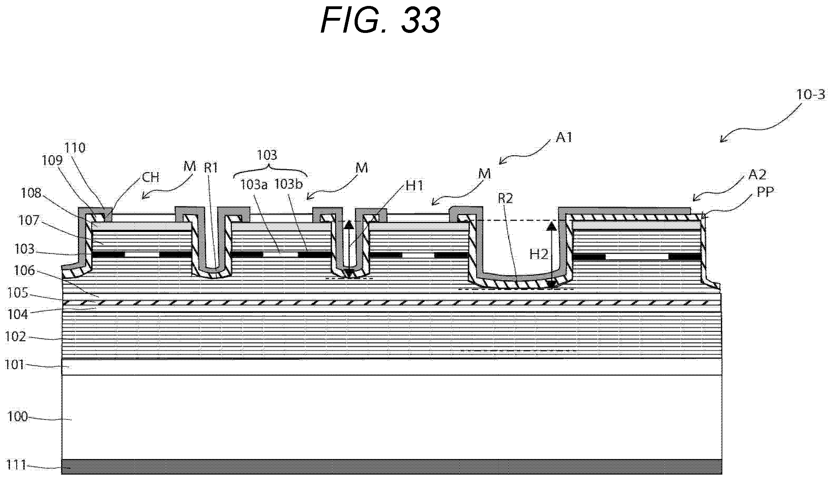

Fig. 33 is a cross-sectional view of a surface emitting laser element 10-3 of Modification 3 (a cross-sectional view corresponding to the cross-sectional view taken along line V-V of Fig. 3 (Fig. 1)).

As illustrated in Fig. 33, the surface emitting laser element 10-3 according to Modification 3 has substantially a similar configuration to the surface emitting laser element 10 of one embodiment except that both the bottom surface of the first recess portion R1 and the bottom surface of the second recess portion R2 are located in the second multilayer film reflector 107.

In the surface emitting laser element 10-3, the oxidation confinement layer 103 is provided in the second multilayer film reflector 107.

In the surface emitting laser element 10-3, each mesa M and the protruding portion PP do not have the active layer 105.

The surface emitting laser element 10-3 exhibits substantially similar effects to the surface emitting laser element 10 of one embodiment.

The surface emitting laser element 10-3 can also be manufactured by a manufacturing method similar to the manufacturing method of the surface emitting laser element 10.

### (Surface Emitting Laser Element According to Modification 4)

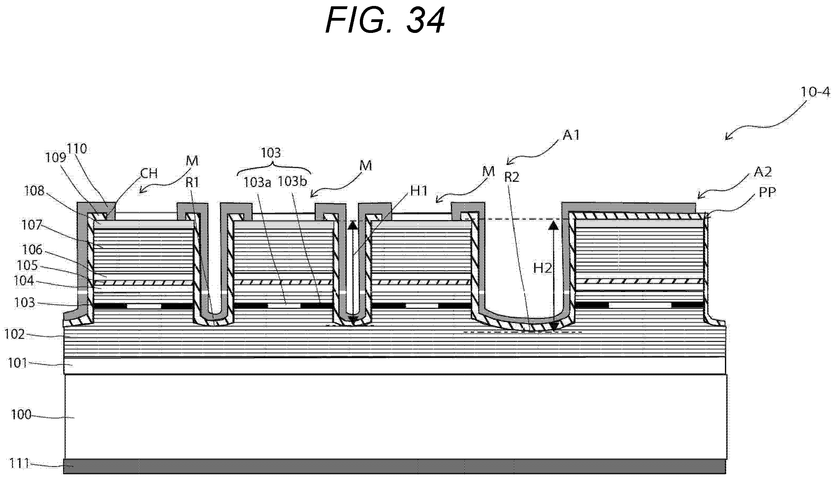

Fig. 34 is a cross-sectional view of a surface emitting laser element 10-4 of Modification 4 (a cross-sectional view corresponding to the cross-sectional view taken along line V-V of Fig. 3 (Fig. 1)).

In the surface emitting laser element 10-4 according to Modification 4, as illustrated in Fig. 34, both the bottom surface of the first recess portion R1 and the bottom surface of the second recess portion R2 are located in the first multilayer film reflector 107.

In the surface emitting laser element 10-4, H2 - H1 is smaller than that of the surface emitting laser element 10 of one embodiment.

The surface emitting laser element 10-4 exhibits substantially similar effects to the surface emitting laser element 10 of one embodiment, but since the reduction degree of the resistance difference is lower than that of the surface emitting laser element 10 of one embodiment, it is particularly effective in a case where the difference in electric resistance between the outermost peripheral mesas and the other mesa M becomes small (for example, a case where the mesa pitch is relatively large or the like).

The surface emitting laser element 10-4 can also be manufactured by a manufacturing method similar to the manufacturing method of the surface emitting laser element 10.

### (Surface Emitting Laser Element According to Modification 5)

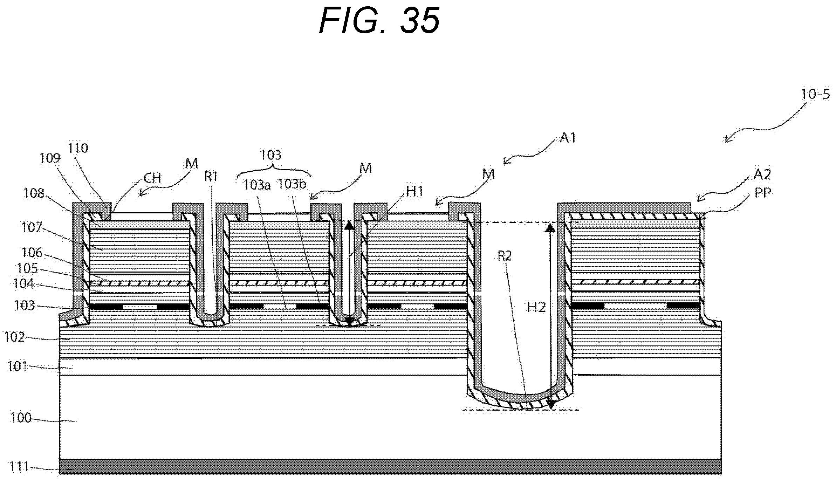

Fig. 35 is a cross-sectional view of a surface emitting laser element 10-5 of Modification 5 (a cross-sectional view corresponding to the cross-sectional view taken along line V-V of Fig. 3 (Fig. 1)).

As illustrated in Fig. 35, the surface emitting laser element 10-5 according to Modification 5 has a similar configuration to the surface emitting laser element 10-1 of Modification 1 except for the size of H2 - H1.

In the surface emitting laser element 10-5, H2 - H1 is larger than that in the surface emitting laser element 10-1 of Modification 1.

The surface emitting laser element 10-5 exhibits substantially similar effects to the surface emitting laser element 10 of one embodiment, but has a higher reduction degree of the resistance difference than the surface emitting laser element 10-1 of Modification 1, and thus is particularly effective in a case where the difference in electric resistance between the outermost peripheral mesas and the other mesas M becomes large (for example, a case where the mesa pitch is relatively small or the like).

The surface emitting laser element 10-5 can also be manufactured by a manufacturing method similar to the manufacturing method of the surface emitting laser element 10 of one embodiment.

### (Surface Emitting Laser Element According to Modification 6)

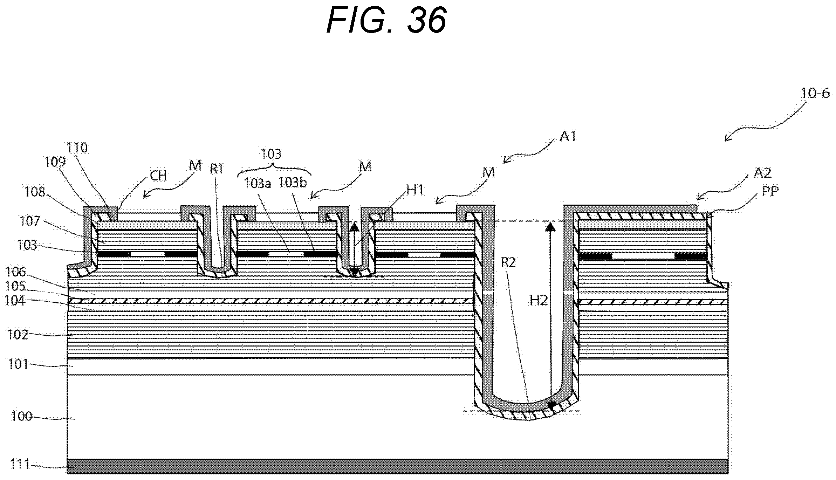

Fig. 36 is a cross-sectional view of a surface emitting laser element 10-6 of Modification 6 (a cross-sectional view corresponding to the cross-sectional view taken along line V-V of Fig. 3 (Fig. 1)).

As illustrated in Fig. 36, the surface emitting laser element 10-6 according to Modification 6 has a similar configuration to the surface emitting laser element 10 of one embodiment except that the bottom surface of the first recess portion R1 is located in the second multilayer film reflector 107 and the bottom surface of the second recess portion R2 is located in the substrate 100.

In the surface emitting laser element 10-6, the oxidation confinement layer 103 is provided in the second multilayer film reflector 107.

In the surface emitting laser element 10-6, each mesa M does not have the active layer 105.

The surface emitting laser element 10-6 exhibits substantially similar effects to the surface emitting laser element 10 of one embodiment, but since H2 - H1 is larger than that of the surface emitting laser element 10 of one embodiment, the reduction degree of the resistance difference is large, and since the bottom surface of the second recess portion R2 is located in the substrate 100, the effect of suppressing the spread of the current from the outermost peripheral mesas to the second region A2 side is high.

That is, the surface emitting laser element 10-6 is particularly effective in a case where the mesa pitch is small and the resistance difference between the outermost peripheral mesas and the other mesas M is large.

The surface emitting laser element 10-6 can also be manufactured by a manufacturing method similar to the manufacturing method of the surface emitting laser element 10 of one embodiment.

### (Surface Emitting Laser Element According to Modification 7)

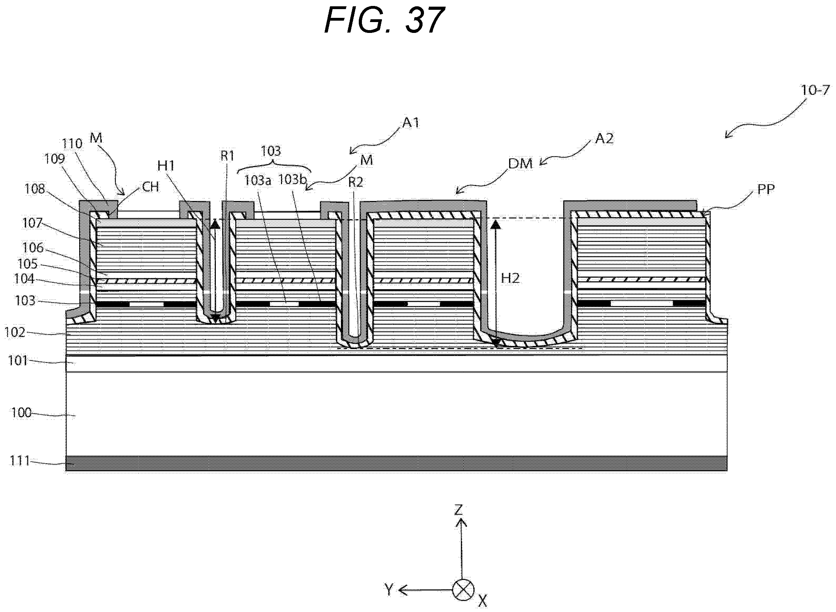

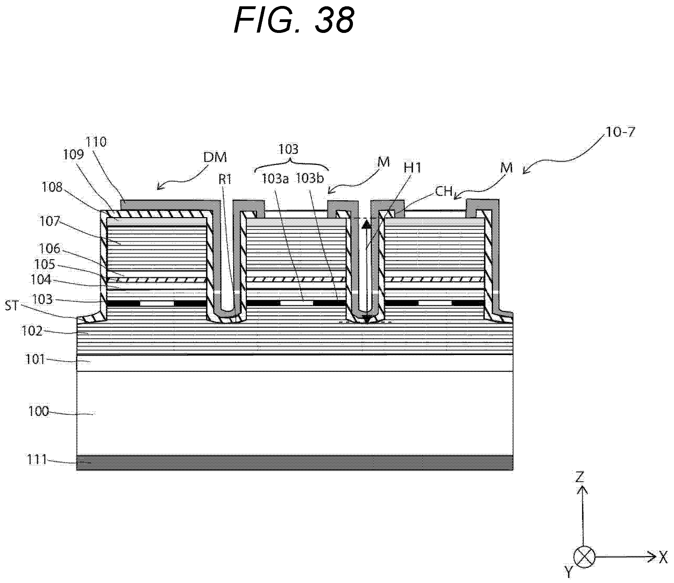

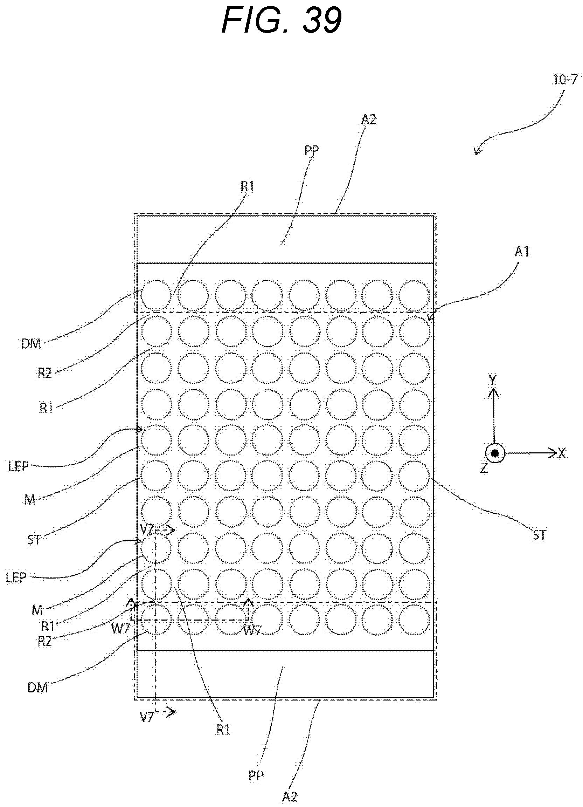

Fig. 37 is a cross-sectional view (part 1) of a surface emitting laser element 10-7 of Modification 7. Fig. 38 is a cross-sectional view (part 2) of a surface emitting laser element 10-7 of Modification 7. Fig. 39 is a plan view of a surface emitting laser element 10-7 of Modification 7. Fig. 37 is a cross-sectional view (YZ cross-sectional view) taken along line V7-V7 in Fig. 39. Fig. 38 is a cross-sectional view (XZ cross-sectional view) taken along line W7-W7 in Fig. 39.

As illustrated in Figs. 37 to 39, the surface emitting laser element 10-7 according to Modification 7 has a similar configuration to the surface emitting laser element 10 of one embodiment except that the second region A2 includes dummy mesas DM adjacent to the mesas M adjacent to the second region A2 (the outermost peripheral mesas of the first region A1), and the second recess portion R2 is defined by the mesas M adjacent to the second region A2 and the dummy mesas DM.

The dummy mesa DM is a mesa included in a non-light emitting unit that is not provided with the contact hole CH and the anode electrode 110 and is not energized.

More specifically, in the surface emitting laser element 10-7, each second region A2 includes the dummy mesas DM provided between the protruding portion PP and the first region A1, and the protruding portion PP.

In the surface emitting laser element 10-7, the second recess portion R2 is defined by the outermost peripheral mesas in the first region A1 and the dummy mesas DM in the second region A2.

According to the surface emitting laser element 10-7, the current flowing through the mesas M (the outermost peripheral mesas of the first region A1) adjacent to the dummy mesas DM is suppressed from spreading to the dummy mesa DM side. As a result, the electric resistance of the outermost peripheral mesas is suppressed from being lowered, the current is suppressed from being concentrated on the outermost peripheral mesas, and the variation in the light emission intensity between the outermost peripheral mesas and the mesas M other than the outermost peripheral mesas can be reduced.

The surface emitting laser element 10-7 can also be manufactured by a manufacturing method substantially similar to the manufacturing method of the surface emitting laser element 10 of one embodiment.

### (Surface Emitting Laser Element According to Modification 8)

Fig. 38 is a plan view of a surface emitting laser element 10-8 of Modification 8.

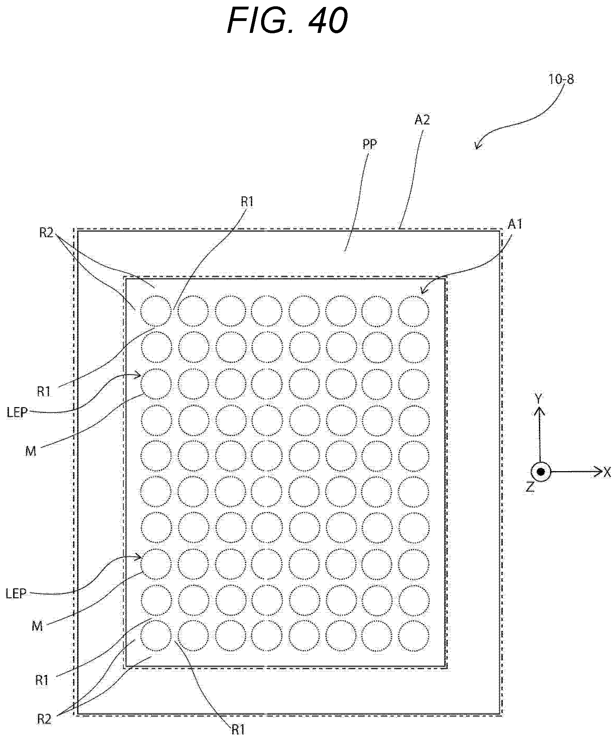

In the surface emitting laser element 10-8 according to Modification 8, as illustrated in Fig. 40, the second region A2 has a frame-like shape in plan view (a region surrounded by two-dot chain lines in Fig. 40).

In the surface emitting laser element 10-8, the YZ cross section obtained by cutting the second region A2 and the plurality of mesas M together and the XZ cross section obtained by cutting the second region A2 and the plurality of mesas M together are similar. The YZ cross section and the XZ cross section of the surface emitting laser element 10-8 are similar to the YZ cross section of any one of the surface emitting laser elements 10, 10-1 to 10-6 of one embodiment and Modification 1 to 6.

The surface emitting laser element 10-8 exhibits substantially similar effects to the surface emitting laser element 10 of one embodiment.

The surface emitting laser element 10-8 can also be manufactured by a manufacturing method similar to the manufacturing method of the surface emitting laser element 10 of one embodiment.

### (Surface Emitting Laser Element According to Modification 9)

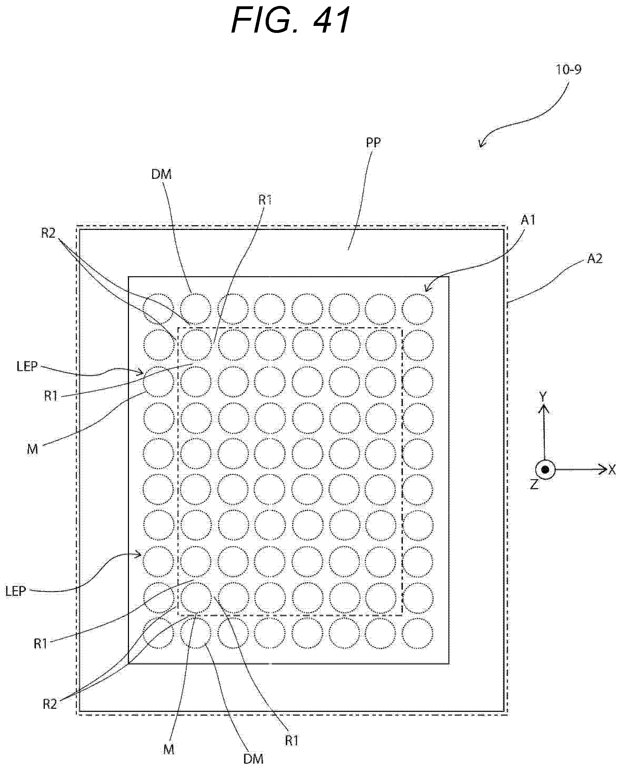

Fig. 41 is a plan view of a surface emitting laser element 10-9 of Modification 9.

In the surface emitting laser element 10-9 according to Modification 9, as illustrated in Fig. 41, the second region A2 has a frame-like shape in plan view (a region surrounded by two-dot chain lines in Fig. 41).

In the surface emitting laser element 10-9, the YZ cross section obtained by cutting the second region A2 and the plurality of mesas M together and the XZ cross section obtained by cutting the second region A2 and the plurality of mesas M together are similar. The YZ cross section and the XZ cross section of the surface emitting laser element 10-9 are similar to the YZ cross section of the surface emitting laser element 10-7 of Modification 7.

The surface emitting laser element 10-9 exhibits substantially similar effects to the surface emitting laser element 10-7 of Modification 7.

The surface emitting laser element 10-9 can also be manufactured by a manufacturing method similar to the manufacturing method of the surface emitting laser element 10 of one embodiment.

### 8. <Other Modifications of Embodiment of Present Technology>

The surface emitting laser element according to the present technology is not limited to the configuration described in the above-described embodiment and each modification, and can be appropriately changed.

In the above embodiment and each modification, the surface emitting type in which the light emitting unit emits light from the top portion side of the mesa has been described as an example of the surface emitting laser element of the present technology, but the surface emitting laser element of the present technology can also be applied to a back surface emitting type in which the light emitting unit emits light to the back surface side of the substrate. In this case, it is necessary to provide an opening serving as an emission port at a position corresponding to each light emitting unit in the electrode provided on the back surface of the substrate.

In the above-described embodiment and each modification, the anode electrode is provided on the top portion side of the mesa M, and the cathode electrode is provided on the back surface side of the substrate 100, but the cathode electrode may be provided on the top portion side of the mesa M, and the anode electrode may be provided on the back surface side of the substrate 100. In this case, it is also necessary to replace the conductivity types (p-type and n-type).

In the above-described embodiment and each modification, both the first and second multilayer film reflectors 102 and 107 are semiconductor multilayer film reflectors, but are not limited thereto.

For example, the first multilayer film reflector 102 may be a semiconductor multilayer film reflector, and the second multilayer film reflector 107 may be a dielectric multilayer film reflector. The dielectric multilayer film reflector is also a kind of distributed Bragg reflector.

For example, the first multilayer film reflector 102 may be a dielectric multilayer film reflector, and the second multilayer film reflector 107 may be a semiconductor multilayer film reflector.

For example, both the first and second multilayer film reflectors 102 and 107 may be dielectric multilayer film reflectors.

In the surface emitting laser element of the above-described embodiment and each modification, the spacer layer 101 may not necessarily be provided.

In the surface emitting laser element of the above-described embodiment and each modification, the oxidation confinement layer 103 may be provided inside any one of the first and second cladding layers 104 and 106.

In the surface emitting laser element of the above-described embodiment and each modification, the contact layer 108 may not necessarily be provided.

Some of the configurations of the surface emitting laser elements of the above-described embodiment and each modification may be combined within a range in which they do not contradict each other. For example, as in the surface emitting laser element of Modification 10, the bottom surface of the first recess portion R1 may be located in the second multilayer film reflector 107, and the bottom surface of the second recess portion R2 may be located in the first multilayer film reflector 102.

In the embodiment and each modification described above, the material, conductivity type, thickness, width, length, shape, size, arrangement, and the like of each component constituting the surface emitting laser element can be appropriately changed within a range functioning as the surface emitting laser element.

### 9. Application Example to Electronic Device

The technology according to the present disclosure (the present technology) can be applied to various products (electronic devices). For example, the technology according to the present disclosure may be implemented as an element mounted on any type of mobile body such as an automobile, an electric vehicle, a hybrid electric vehicle, a motorcycle, a bicycle, a personal mobility, an airplane, a drone, a ship, a robot, and the like.

The surface emitting laser element according to the present technology can also be applied as, for example, a light source of a device that forms or displays an image by laser light (for example, a laser printer, a laser copier, a projector, a head-mounted display, a head-up display, or the like).

### 10. <Example in Which Surface Emitting Laser Element Is Applied to Distance Measuring Device>

Hereinafter, application examples of the surface emitting laser element according to the above-described embodiment and each modification will be described.

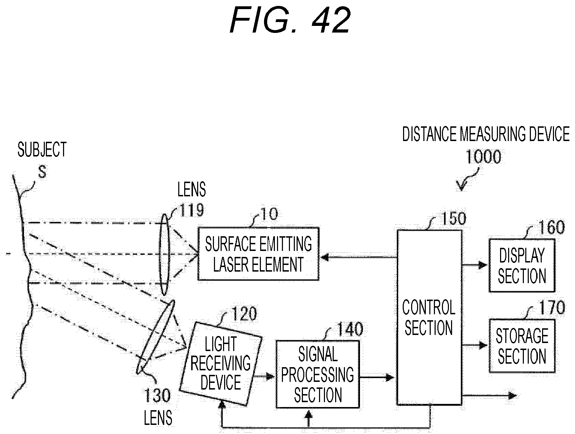

Fig. 42 illustrates an example of a schematic configuration of a distance measuring device 1000 including the surface emitting laser element 10 as an example of an electronic device according to the present technology. The distance measuring device 1000 measures the distance to a subject S by a time of flight (TOF) method. The distance measuring device 1000 includes the surface emitting laser element 10 as a light source. The distance measuring device 1000 includes, for example, the surface emitting laser element 10, a light receiving device 125, lenses 115 and 135, a signal processing section 140, a control section 150, a display section 160, and a storage section 170.

The light receiving device 125 detects light reflected by the subject S. The lens 115 is a lens for collimating the light emitted from the surface emitting laser element 10, and is a collimating lens. The lens 135 is a lens for condensing the light reflected by the subject S and guiding the light to the light receiving device 125, and is a condenser lens.

The signal processing section 140 is a circuit for generating a signal corresponding to a difference between a signal input from the light receiving device 125 and a reference signal input from the control section 150. The control section 150 includes, for example, a time-to-digital converter (TDC). The reference signal may be a signal input from the control section 150, or may be an output signal of a detecting section that directly detects the output of the surface emitting laser element 10. The control section 150 is, for example, a processor that controls the surface emitting laser element 10, the light receiving device 125, the signal processing section 140, the display section 160, and the storage section 170. The control section 150 is a circuit that measures a distance to the subject S on the basis of a signal generated by the signal processing section 140. The control section 150 generates a video signal for displaying information about the distance to the subject S, and outputs the video signal to the display section 160. The display section 160 displays information about the distance to the subject S on the basis of the video signal input from the control section 150. The control section 150 stores information about the distance to the subject S in the storage section 170.

In the present application example, instead of the surface emitting laser element 10, any one of the above-described surface emitting laser elements 10-1, 10-2, 10-3, 10-4, 10-5, 10-6, 10-7, 10-8, and 10-9 can be applied to the distance measuring device 1000.

### 11. < Example in which Distance Measuring Device Is Mounted on Mobile Body>

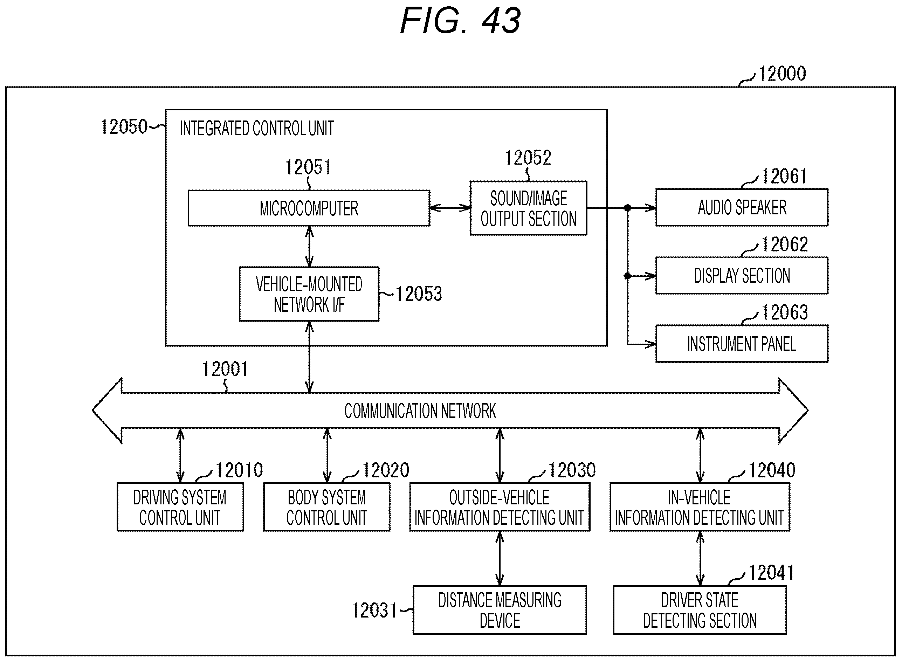

Fig. 43 is a block diagram illustrating a schematic configuration example of a vehicle control system that is an example of a mobile body control system to which the technology according to the present disclosure may be applied.

A vehicle control system 12000 includes a plurality of electronic control units connected to each other via a communication network 12001. In the example illustrated in Fig. 43, the vehicle control system 12000 is provided with a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as the functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information outside the vehicle on which the vehicle control system 12000 is mounted. For example, a distance measuring device 12031 is connected to the outside-vehicle information detecting unit 12030. The distance measuring device 12031 includes the above-described distance measuring device 1000. The outside-vehicle information detecting unit 12030 causes the distance measuring device 12031 to measure a distance to an object (subject S) outside the vehicle, and acquires distance data obtained by the measurement. The outside-vehicle information detecting unit 12030 may perform object detection processing of a person, a vehicle, an obstacle, a sign, or the like on the basis of the acquired distance data.

The in-vehicle information detecting unit 12040 detects information inside the vehicle. The in-vehicle information detecting unit 12040 is, for example, connected with a driver state detecting section 12041 that detects the state of a driver. The driver state detecting section 12041 includes, for example, a camera that captures an image of the driver, and the in-vehicle information detecting unit 12040 may calculate the degree of fatigue or the degree of concentration of the driver or may determine whether or not the driver is dozing off on the basis of the detection information input from the driver state detecting section 12041.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

Furthermore, the microcomputer 12051 controls the driving force generating device, the steering mechanism, the braking device, or the like on the basis of the information around the vehicle acquired by the outside-vehicle information detecting unit 12030 or the in-vehicle information detecting unit 12040, thereby performing cooperative control for the purpose of automated driving or the like in which the vehicle autonomously travels without depending on the operation of the driver.

Furthermore, the microcomputer 12051 can output a control command to the body system control unit 12020 on the basis of the vehicle exterior information acquired by the outside-vehicle information detecting unit 12030. For example, the microcomputer 12051 can perform cooperative control for the purpose of preventing glare, such as switching from a high beam to a low beam, by controlling the headlamp according to the position of a preceding vehicle or an oncoming vehicle detected by the outside-vehicle information detecting unit 12030.

The sound/image output section 12052 transmits an output signal of at least one of a sound or an image to an output device capable of visually or auditorily notifying an occupant of the vehicle or the outside of the vehicle of information. In the example in Fig. 43, as the output device, an audio speaker 12061, a display section 12062, and an instrument panel 12063 are illustrated. The display section 12062 may, for example, include at least one of an on-board display or a head-up display.

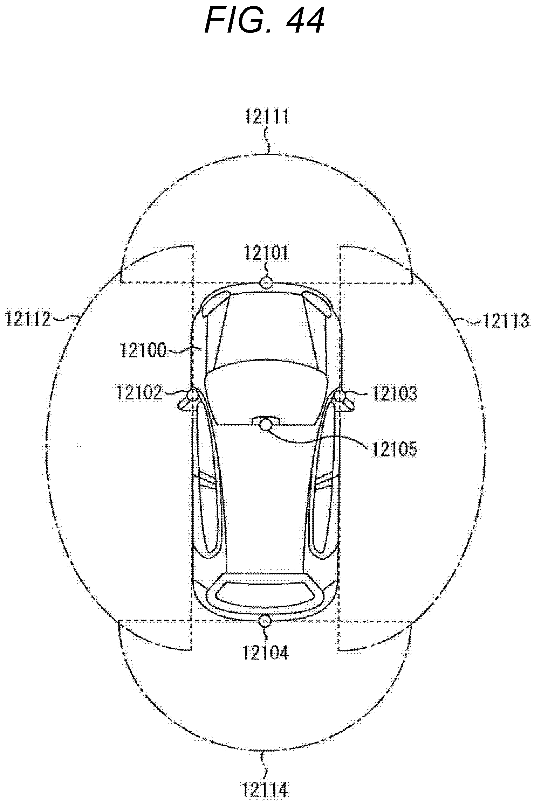

Fig. 44 is a view illustrating an example of an installation position of the distance measuring device 12031.

In Fig. 44, a vehicle 12100 includes distance measuring devices 12101, 12102, 12103, 12104, and 12105 as the distance measuring device 12031.

The distance measuring devices 12101, 12102, 12103, 12104, and 12105 are provided, for example, at positions such as a front nose, sideview mirrors, a rear bumper, a back door, and an upper portion of a windshield in a vehicle interior of the vehicle 12100. The distance measuring device 12101 provided on the front nose and the distance measuring device 12105 provided on the upper portion of the windshield in the vehicle cabin mainly acquire data of the front side of the vehicle 12100. The distance measuring devices 12102 and 12103 provided at the sideview mirrors mainly acquire data on the sides of the vehicle 12100. The distance measuring device 12104 provided on the rear bumper or the back door mainly acquires data behind the vehicle 12100. The data in front of the vehicle acquired by the distance measuring devices 12101 and 12105 is mainly used for detecting a preceding vehicle, a pedestrian, an obstacle, a traffic light, a traffic sign, or the like.

Note that Fig. 44 illustrates an example of detection ranges of the distance measuring devices 12101 to 12104. A detection range 12111 indicates a detection range of the distance measuring device 12101 provided on the front nose, detection ranges 12112 and 12113 indicate detection ranges of the distance measuring devices 12102 and 12103 provided at the sideview mirrors, respectively, and a detection range 12114 indicates a detection range of the distance measuring device 12104 provided on the rear bumper or the back door.

For example, the microcomputer 12051 obtains a distance to each three-dimensional object in the detection ranges 12111 to 12114 and a temporal change of the distance (relative speed with respect to the vehicle 12100) on the basis of the distance data obtained from the distance measuring devices 12101 to 12104, thereby extracting, as a preceding vehicle, a three-dimensional object traveling at a predetermined speed (for example, 0 km/h or more) in substantially the same direction as the vehicle 12100, in particular, the closest three-dimensional object on a traveling path of the vehicle 12100. Moreover, the microcomputer 12051 can set a following distance to be maintained in front of a preceding vehicle in advance, and perform automatic brake control (including following stop control), automatic acceleration control (including following start control), or the like. In this way, it is possible to perform cooperative control for the purpose of automated driving or the like in which the vehicle autonomously travels without depending on the operation of the driver.

For example, on the basis of the distance data obtained from the distance measuring devices 12101 to 12104, the microcomputer 12051 can classify three-dimensional object data regarding three-dimensional objects into two-wheeled vehicles, standard-sized vehicles, large-sized vehicles, pedestrians, and other three-dimensional objects such as utility poles, extract the three-dimensional object data, and use the three-dimensional object data for automatic avoidance of obstacles. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is higher than or equal to a set value and there is thus a possibility of collision, the microcomputer 12051 can outputs a warning to the driver via the audio speaker 12061 or the display section 12062 and perform forced deceleration or avoidance steering via the driving system control unit 12010 to perform driving assistance for collision avoidance.

An example of a mobile body control system to which the technology according to the present disclosure can be applied has been described above. The technology according to the present disclosure can be applied to the distance measuring device 12031 among the configurations described above.

### REFERENCE SIGNS LIST

- 10, 10-1 to 10-9: Surface emitting laser element
- 100: Substrate
- 100a: One surface of substrate
- 100b: Other surface of substrate
- 102: First multilayer film reflector
- 103: Oxidation confinement layer
- 105: Active layer
- 107: Second multilayer film reflector
- 110: Anode electrode (another electrode)
- 111: Cathode electrode (electrode)
- 1000: Distance measuring device (electronic device)
- LEP: Light emitting unit
- A1: First region
- A2: Second region
- M: Mesa
- DM: Dummy mesa
- R1: First recess portion
- R2: Second recess portion
- H1: Depth dimension of first recess portion
- H2: Depth dimension of second recess portion.

## Claims

1. A surface emitting laser element (10) comprising:
a substrate (100);
an electrode (111) provided on one surface (100a) of the substrate;
a first region (A1) which is provided on a side of the one surface opposite to a side of the electrode and in which a plurality of light emitting units (LEP) having mesas (M) is arranged; and
a second region (A2) disposed around the first region on a side of the one surface opposite to the side of the electrode,
wherein a depth dimension (H2) of a second recess portion (R2) defined by a mesa adjacent to the second region among the mesas of the plurality of light emitting units and the second region is larger than a depth dimension (H1) of a first recess portion (R1) defined by two mesas adjacent to each other among the mesas of the plurality of light emitting units; **characterized in that**
the second region includes a dummy mesa (DM) adjacent to the mesa adjacent to the second region, and
the second recess portion is defined by the mesa adjacent to the second region and the dummy mesa.

2. The surface emitting laser element according to claim 1, wherein the electrode is a common electrode provided in common for the plurality of light emitting units.

3. The surface emitting laser element according to claim 1, wherein a bottom surface of the second recess portion is located at a position closer to the one surface than a bottom surface of the first recess portion in a direction perpendicular to the substrate.

4. The surface emitting laser element according to claim 1, wherein open ends of the first and second recess portions are substantially flush; or wherein bottom surfaces of the first and second recess portions are both located on a side of an other surface of the substrate opposite to the side of the one surface.

5. The surface emitting laser element according to claim 1, wherein either
i) a bottom surface of the first recess portion is located on a side of an other surface of the substrate opposite to the side of the one surface, and a bottom surface of the second recess portion is located in the substrate; or
ii) wherein bottom surfaces of the first and second recess portions are both located in the substrate.

6. The surface emitting laser element according to claim 1, wherein the first and second regions are provided at different positions in an in-plane direction of a laminated structure including the substrate, and
in the laminated structure, a first multilayer film reflector, an active layer, and a second multilayer film reflector are laminated in this order on a side of the one surface opposite to the side of the electrode.

7. The surface emitting laser element according to claim 6, wherein bottom surfaces of the first and second recess portions are both located in the first multilayer film reflector.

8. The surface emitting laser element according to claim 6, wherein either
i) a bottom surface of the first recess portion is located in the second multilayer film reflector, and a bottom surface of the second recess portion is located in the first multilayer film reflector; or
ii) wherein a bottom surface of the first recess portion is located in the first multilayer film reflector, and a bottom surface of the second recess portion is located in the substrate.

9. The surface emitting laser element according to claim 6, wherein either
i) a bottom surface of the first recess portion is located in the second multilayer film reflector, and a bottom surface of the second recess portion is located in the substrate; or
ii) bottom surfaces of the first and second recess portions are both located in the second multilayer film reflector.

10. The surface emitting laser element according to claim 1, wherein a width of the second recess portion is larger than a width of the first recess portion in a cross section obtained by cutting the two mesas adjacent to each other and the second region together; or wherein an interval between centers of the two mesas adjacent to each other is 10 µm or more and 50 µm or less.

11. The surface emitting laser element according to claim 1, further comprising another electrode provided so as to be in contact with a top portion of at least one of the mesas adjacent to the second region and top portions of at least two of the mesas not adjacent to the second region.

12. An electronic device comprising the surface emitting laser element according to claim 1.

13. A method for manufacturing a surface emitting laser element (10), the method comprising:
generating a laminate by laminating a first multilayer film reflector (102), an active layer (105), and a second multilayer film reflector (107)in this order on a substrate (100);
forming a first region (A1) in which a plurality of light emitting units (LEP) including mesas (M) is disposed and a second region (A2) around the first region by etching the laminate; and
forming an electrode (111) on a surface (100a) of the substrate on a side opposite to a surface (100b) on a side of the first multilayer film reflector,
wherein in the forming the first and second regions, the laminate is etched such that a depth dimension (H2) of a second recess portion (R2) defined by a mesa adjacent to the second region among the mesas of the plurality of light emitting units and the second region is larger than a depth dimension (H1) of a first recess portion (R1) defined by two mesas adjacent to each other among the mesas of the plurality of light emitting units; **characterized in that**
the second region includes a dummy mesa (DM) adjacent to the mesa adjacent to the second region, and
the second recess portion is defined by the mesa adjacent to the second region and the dummy mesa.

14. The method for manufacturing the surface emitting laser element according to claim 13, wherein in the forming the electrode, the electrode is formed in a region corresponding to at least the first and second regions on the surface of the substrate on the side opposite to the surface on the side of the first multilayer film reflector.

## Patentansprüche

1. Oberflächenemittierendes Laserelement (10), umfassend:
ein Substrat (100);
eine Elektrode (111), die auf einer Oberfläche (100a) des Substrats bereitgestellt ist;
einen ersten Bereich (A1), der auf einer Seite der einen Oberfläche gegenüber einer Seite der Elektrode bereitgestellt ist und in dem eine Vielzahl von lichtemittierenden Einheiten (LEP), die Mesas (M) aufweisen, angeordnet ist; und
einen zweiten Bereich (A2), der auf einer Seite der einen Oberfläche gegenüber der Seite der Elektrode um den ersten Bereich herum eingerichtet ist,
wobei eine Tiefenabmessung (H2) eines zweiten Aussparungsabschnitts (R2), der durch eine Mesa angrenzend an den zweiten Bereich aus den Mesas der Vielzahl von lichtemittierenden Einheiten und den zweiten Bereich definiert ist, größer als eine Tiefenabmessung (H1) eines ersten Aussparungsabschnitts (R1) ist, der durch zwei aneinander angrenzende Mesas aus den Mesas der Vielzahl von lichtemittierenden Einheiten definiert ist;
**dadurch gekennzeichnet, dass** der zweite Bereich eine Dummy-Mesa (DM) angrenzend an die Mesa angrenzend an den zweiten Bereich einschließt, und
der zweite Aussparungsabschnitt durch die Mesa angrenzend an den zweiten Bereich und die Dummy-Mesa definiert wird.

2. Oberflächenemittierendes Laserelement nach Anspruch 1, wobei die Elektrode eine gemeinsame Elektrode ist, die gemeinsam für die Vielzahl von lichtemittierenden Einheiten bereitgestellt ist.

3. Oberflächenemittierendes Laserelement nach Anspruch 1, wobei eine untere Oberfläche des zweiten Aussparungsabschnitts an einer Position näher zu der einen Oberfläche als eine untere Oberfläche des ersten Aussparungsabschnitts in einer Richtung senkrecht zu dem Substrat gelegen ist.

4. Oberflächenemittierendes Laserelement nach Anspruch 1, wobei offene Enden des ersten und des zweiten Aussparungsabschnitts im Wesentlichen bündig sind; oder wobei untere Oberflächen des ersten und des zweiten Aussparungsabschnitts beide auf einer Seite einer anderen Oberfläche des Substrats gegenüber der Seite der einen Oberfläche gelegen sind.

5. Oberflächenemittierendes Laserelement nach Anspruch 1, wobei entweder
i) eine untere Oberfläche des ersten Aussparungsabschnitts auf einer Seite einer anderen Oberfläche des Substrats gegenüber der Seite der einen Oberfläche gelegen ist und eine untere Oberfläche des zweiten Aussparungsabschnitts in dem Substrat gelegen ist; oder
ii) wobei untere Oberflächen des ersten und des zweiten Aussparungsabschnitts beide in dem Substrat gelegen sind.

6. Oberflächenemittierendes Laserelement nach Anspruch 1, wobei der erste und der zweite Bereich an verschiedenen Positionen in einer Richtung in gleicher Ebene einer laminierten Struktur, einschließlich des Substrats, bereitgestellt sind und,
in der laminierten Struktur, ein erster Mehrschichtfilmreflektor, eine aktive Schicht und ein zweiter Mehrschichtfilmreflektor in dieser Reihenfolge auf einer Seite der einen Oberfläche gegenüber der Seite der Elektrode laminiert sind.

7. Oberflächenemittierendes Laserelement nach Anspruch 6, wobei untere Oberflächen des ersten und des zweiten Aussparungsabschnitts beide in dem ersten Mehrschichtfilmreflektor gelegen sind.

8. Oberflächenemittierendes Laserelement nach Anspruch 6, wobei entweder
i) eine untere Oberfläche des ersten Aussparungsabschnitts in dem zweiten Mehrschichtfilmreflektor gelegen ist und eine untere Oberfläche des zweiten Aussparungsabschnitts in dem ersten Mehrschichtfilmreflektor gelegen ist; oder
ii) wobei eine untere Oberfläche des ersten Aussparungsabschnitts in dem ersten Mehrschichtfilmreflektor gelegen ist und eine untere Oberfläche des zweiten Aussparungsabschnitts in dem Substrat gelegen ist.

9. Oberflächenemittierendes Laserelement nach Anspruch 6, wobei entweder
i) eine untere Oberfläche des ersten Aussparungsabschnitts in dem zweiten Mehrschichtfilmreflektor gelegen ist und eine untere Oberfläche des zweiten Aussparungsabschnitts in dem Substrat gelegen ist; oder
ii) untere Oberflächen des ersten und des zweiten Aussparungsabschnitts beide in dem zweiten Mehrschichtfilmreflektor gelegen sind.

10. Oberflächenemittierendes Laserelement nach Anspruch 1, wobei eine Breite des zweiten Aussparungsabschnitts größer als eine Breite des ersten Aussparungsabschnitts in einem Querschnitt ist, der durch Zusammenschneiden der zwei aneinander angrenzenden Mesas und des zweiten Bereichs erhalten wird; oder wobei ein Abstand zwischen Mittelpunkten der zwei aneinander angrenzenden Mesas 10 µm oder mehr und 50 µm oder weniger beträgt.

11. Oberflächenemittierendes Laserelement nach Anspruch 1, ferner umfassend eine weitere Elektrode, die bereitgestellt ist, um mit einem oberen Abschnitt von mindestens einer der Mesas angrenzend an den zweiten Bereich und oberen Abschnitten von mindestens zwei der Mesas nicht angrenzend an den zweiten Bereich in Kontakt zu sein.

12. Elektronische Vorrichtung, umfassend das oberflächenemittierende Laserelement nach Anspruch 1.

13. Verfahren zum Herstellen eines oberflächenemittierenden Laserelements (10), das Verfahren umfassend:
Erzeugen eines Laminats durch Laminieren eines ersten Mehrschichtfilmreflektors (102), einer aktiven Schicht (105) und eines zweiten Mehrschichtfilmreflektors (107) in dieser Reihenfolge auf ein Substrat (100);
Ausbilden eines ersten Bereichs (A1), in dem eine Vielzahl von lichtemittierenden Einheiten (LEP), einschließlich Mesas (M,) eingerichtet ist, und eines zweiten Bereichs (A2) um den ersten Bereich herum durch Ätzen des Laminats; und
Ausbilden einer Elektrode (111) auf einer Oberfläche (100a) des Substrats auf einer Seite gegenüber einer Oberfläche (100b) auf einer Seite des ersten Mehrschichtfilmreflektors,
wobei, bei dem Ausbilden des ersten und des zweiten Bereichs, das Laminat derart geätzt wird, dass eine Tiefenabmessung (H2) eines zweiten Aussparungsabschnitts (R2), der durch eine Mesa angrenzend an den zweiten Bereich aus den Mesas der Vielzahl von lichtemittierenden Einheiten und den zweiten Bereich definiert wird, größer als eine Tiefenabmessung (H1) eines ersten Aussparungsabschnitts (R1) ist, der durch zwei aneinander angrenzende Mesas aus den Mesas der Vielzahl von lichtemittierenden Einheiten definiert wird;
**dadurch gekennzeichnet, dass** der zweite Bereich eine Dummy-Mesa (DM) angrenzend an die Mesa angrenzend an den zweiten Bereich einschließt, und
der zweite Aussparungsabschnitt durch die Mesa angrenzend an den zweiten Bereich und die Dummy-Mesa definiert wird.

14. Verfahren zum Herstellen des oberflächenemittierenden Laserelements nach Anspruch 13, wobei, bei dem Ausbilden der Elektrode, die Elektrode in einem Bereich entsprechend mindestens dem ersten und dem zweiten Bereich auf der Oberfläche des Substrats auf der Seite gegenüber der Oberfläche auf der Seite des ersten Mehrschichtfilmreflektors ausgebildet wird.

## Revendications

1. Élément laser à émission par la surface (10) comprenant :
un substrat (100) ;
une électrode (111) prévue sur une surface (100a) du substrat ;
une première région (A1) qui est prévue sur un côté de ladite surface opposé à un côté de l'électrode et dans laquelle une pluralité d'unités d'émission de lumière (LEP) ayant des mesas (M) est agencée ; et
une seconde région (A2) disposée autour de la première région sur un côté de ladite surface opposé au côté de l'électrode,
dans lequel une dimension en profondeur (H2) d'une seconde partie évidée (R2) définie par une mesa à proximité de la seconde région parmi les mesas de la pluralité d'unités d'émission de lumière et la seconde région est plus grande qu'une dimension en profondeur (H1) d'une première partie évidée (R1) définie par deux mesas à proximité l'une de l'autre parmi les mesas de la pluralité d'unités d'émission de lumière ; **caractérisé en ce que** la seconde région comporte une mesa factice (DM) à proximité de la mesa à proximité de la seconde région, et
la seconde partie évidée est définie par la mesa à proximité de la seconde région et la mesa factice.

2. Élément laser à émission par la surface selon la revendication 1, dans lequel l'électrode est une électrode commune fournie en commun pour la pluralité d'unités d'émission de lumière.

3. Élément laser à émission par la surface selon la revendication 1, dans lequel une surface inférieure de la seconde partie évidée est située au niveau d'une position plus proche de ladite surface qu'une surface inférieure de la première partie évidée dans une direction perpendiculaire au substrat.

4. Élément laser à émission par la surface selon la revendication 1, dans lequel des extrémités ouvertes des première et seconde parties évidées sont sensiblement affleurantes ; ou dans lequel des surfaces inférieures des première et seconde parties évidées sont toutes deux situées sur un côté d'une autre surface du substrat opposé au côté de ladite surface.

5. Élément laser à émission par la surface selon la revendication 1, dans lequel soit
i) une surface inférieure de la première partie évidée est située sur un côté d'une autre surface du substrat opposé au côté de ladite surface, et une surface inférieure de la seconde partie évidée est située dans le substrat ; ou
ii) dans lequel des surfaces inférieures des première et seconde parties évidées sont toutes deux situées dans le substrat.

6. Élément laser à émission par la surface selon la revendication 1, dans lequel les première et seconde régions sont prévues au niveau de positions différentes dans une direction dans le plan d'une structure stratifiée comportant le substrat, et
dans la structure stratifiée, un premier réflecteur de film multicouche, une couche active et un second réflecteur de film multicouche sont stratifiés dans cet ordre sur un côté de ladite surface opposé au côté de l'électrode.

7. Élément laser à émission par la surface selon la revendication 6, dans lequel des surfaces inférieures des première et seconde parties évidées sont toutes deux situées dans le premier réflecteur de film multicouche.

8. Élément laser à émission par la surface selon la revendication 6, dans lequel soit
i) une surface inférieure de la première partie évidée est située dans le second réflecteur de film multicouche, et une surface inférieure de la seconde partie évidée est située dans le premier réflecteur de film multicouche ; ou
ii) dans lequel une surface inférieure de la première partie évidée est située dans le premier réflecteur de film multicouche, et une surface inférieure de la seconde partie évidée est située dans le substrat.

9. Élément laser à émission par la surface selon la revendication 6, dans lequel soit
i) une surface inférieure de la première partie évidée est située dans le second réflecteur de film multicouche, et une surface inférieure de la seconde partie évidée est située dans le substrat ; ou
ii) des surfaces inférieures des première et seconde parties évidées sont toutes deux situées dans le second réflecteur de film multicouche.

10. Élément laser à émission de surface selon la revendication 1, dans lequel une largeur de la seconde partie évidée est supérieure à une largeur de la première partie évidée dans une section transversale obtenue en coupant les deux mesas à proximité l'une de l'autre et la seconde région ensemble ; ou dans lequel un intervalle entre des centres des deux mesas à proximité l'une de l'autre est égal ou supérieur à 10 µm et égal ou inférieur à 50 µm.

11. Élément laser à émission de surface selon la revendication 1, comprenant en outre une autre électrode prévue de manière à être en contact avec une partie supérieure d'au moins l'une parmi les mesas à proximité de la seconde région et des parties supérieures d'au moins deux des mesas qui ne sont pas à proximité de la seconde région.

12. Dispositif électronique comprenant l'élément laser à émission par la surface selon la revendication 1.

13. Procédé de fabrication d'un élément laser à émission par la surface (10), le procédé comprenant :
la génération d'un stratifié en stratifiant un premier réflecteur de film multicouche (102), une couche active (105) et un second réflecteur de film multicouche (107) dans cet ordre sur un substrat (100) ;
la formation d'une première région (A1) dans laquelle une pluralité d'unités d'émission de lumière (LEP) comportant des mesas (M) est disposée et d'une seconde région (A2) autour de la première région par gravure du stratifié ; et
la formation d'une électrode (111) sur une surface (100a) du substrat sur un côté opposé à une surface (100b) sur un côté du premier réflecteur de film multicouche,
dans lequel, dans la formation des première et seconde régions, le stratifié est gravé de telle sorte qu'une dimension en profondeur (H2) d'une seconde partie évidée (R2) définie par une mesa à proximité de la seconde région parmi les mesas de la pluralité d'unités d'émission de lumière et la seconde région est plus grande qu'une dimension en profondeur (H1) d'une première partie évidée (R1) définie par deux mesas à proximité l'une de l'autre parmi les mesas de la pluralité d'unités d'émission de lumière ; **caractérisé en ce que** la seconde région comporte une mesa factice (DM) à proximité de la mesa à proximité de la seconde région, et
la seconde partie évidée est définie par la mesa à proximité de la seconde région et la mesa factice.

14. Procédé de fabrication de l'élément laser à émission par la surface selon la revendication 13, dans lequel lors de la formation de l'électrode, l'électrode est formée dans une région correspondant au moins aux première et seconde régions sur la surface du substrat sur le côté opposé à la surface sur le côté du premier réflecteur de film multicouche.
